# EUROPEAN PATENT APPLICATION

(11) **EP 4 571 470 A1**
(43) Date of publication of application: **18.06.2025**
(21) Application number: 24217938.0
(22) Date of filing: 06.12.2024
(51) Int. Cl.: G06F 3/041, G06F 3/044

(54) **ELECTRONIC DEVICE, DISPLAY DEVICE, AND METHOD OF MANUFACTURING THE DISPLAY DEVICE**

(30) Priority: 11.12.2023 KR 20230178289
(71) Applicant: Samsung Display Co., Ltd., Gyeonggi-Do (KR)
(72) Inventor: Lee, Seungchan, Suwon-si, Gyeonggi-Do (KR); Ko, Gyung-Min, Yongin-si, Gyeonggi-Do (KR); Kang, Cheolku, Yongin-si, Gyeonggi-Do (KR); Choi, Donghee, Yongin-si, Gyeonggi-Do (KR)
(74) Representative: Gulde & Partner

(57) **Abstract**

A display device includes: a display panel comprising a plurality of light emitting areas; and an input sensing panel including: a first sensing insulating layer on the display panel; a second sensing insulating layer on the first sensing insulating layer and having a first opening and a contact hole; an insulating pattern; and a plurality of conductive patterns including a first conductive layer and a second conductive layer, the first conductive layer includes: a first-first conductive portion in the first opening; and a first-second conductive portion exposed through the contact hole, the second conductive layer includes: a second-first conductive portion electrically connected to the first-first conductive portion; a second-second conductive portion electrically connected to the first-second conductive portion; and a second-third conductive portion spaced apart from the first conductive layer in a plan view, and the insulating pattern is on the second-first conductive portion and in the first opening.

## Description

### BACKGROUND

### 1. Field

Aspects of some embodiments of the present disclosure relate to an electronic device, a display device, and a method of manufacturing the display device.

### 2. Description of Related Art

Multimedia devices, such as televisions, mobile phones, tablet computers, navigation units, and game units, include a display device to display images to a user through a display screen. The display device includes a display panel generating the images and an input sensor sensing a user input.

The input sensor includes a plurality of conductive patterns that senses an external input, and as a thickness of the conductive patterns increases, a resistance of the conductive patterns decreases. In this case, however, the difficulty in process increases. Accordingly, there is a need to increase the thickness of the conductive patterns and to decrease the difficulty of the processes.

The above information disclosed in this Background section is only for enhancement of understanding of the background and therefore the information discussed in this Background section does not necessarily constitute prior art.

### SUMMARY

Aspects of some embodiments of the present disclosure relate to an electronic device, a display device, and a method of manufacturing the display device. For example, aspects of some embodiments of the present disclosure relate to an electronic device, a display device, and a method of manufacturing the display device, which may have relatively improved resistance.

Aspects of some embodiments include an electronic device with relatively improved resistance.

Aspects of some embodiments include a display device with relatively improved resistance.

Aspects of some embodiments of the present disclosure include a method of manufacturing the display device, which may be capable of relatively reducing a difficulty in a manufacturing process.

Aspects of some embodiments of the present disclosure include a display device including a display panel including a plurality of light emitting areas and an input sensing panel including a first sensing insulating layer on the display panel, a second sensing insulating layer on the first sensing insulating layer and provided with a first opening and a contact hole, which are defined therethrough, an insulating pattern, and a plurality of conductive patterns. According to some embodiments, the conductive patterns include a first conductive layer and a second conductive layer, the first conductive layer includes a first-first conductive portion in the first opening and a first-second conductive portion partially exposed through the contact hole, the second conductive layer includes a second-first conductive portion electrically connected to the first-first conductive portion, a second-second conductive portion electrically connected to the first-second conductive portion, and a second-third conductive portion spaced apart from the first conductive layer in a plan view, and the insulating pattern is on the second-first conductive portion and in the first opening. The second-first conductive portion may be located directly on the first-first conductive portion

According to some embodiments, the first-first conductive portion may have a thickness greater than a thickness of the second-first conductive portion.

According to some embodiments, a sum of a thickness of the first-first conductive portion and a thickness of the second-first conductive portion may be equal to or greater than 2000 angstroms and equal to or smaller than 37500 angstroms, preferably equal to or greater than 6000 angstroms and equal to or smaller than 30000 angstroms, equal to or greater than 12000 angstroms and equal to or smaller than 24000 angstroms.

According to some embodiments, the insulating pattern may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

According to some embodiments, the display device may further include a third conductive layer including a third-first conductive portion on the insulating pattern, a third-second conductive portion directly on the second-second conductive portion, and a third-third conductive portion directly on the second-third conductive portion.

According to some embodiments, the second sensing insulating layer may further include an opening surface that defines the first opening, and the insulating pattern includes a convex portion that overlaps the opening surface in a plan view.

According to some embodiments, the third-second conductive portion may have a size equal to or greater than a size of the second-second conductive portion in a plan view.

According to some embodiments, the third-third conductive portion may have a size equal to or greater than a size of the second-third conductive portion in a plan view.

According to some embodiments, a sum of a thickness of the second-third conductive portion and a thickness of the third-third conductive portion may be equal to or greater than 2000 angstroms and equal to or smaller than 37500 angstroms, preferably equal to or greater than 6000 angstroms and equal to or smaller than 30000 angstroms, equal to or greater than 12000 angstroms and equal to or smaller than 24000 angstroms.

According to some embodiments, the display device may further include a third sensing insulating layer on the third conductive layer.

According to some embodiments, each of the first conductive layer and the second conductive layer may include a conductive material, and the conductive material includes at least one of Ti, Al, Mo, or Cu.

According to some embodiments, the light emitting areas may not overlap the conductive patterns in a plan view.

According to some embodiments, the display panel may further include a light emitting element including a first electrode, a light emitting layer on the first electrode, and a second electrode on the light emitting layer and an encapsulation layer on the light emitting element.

According to some embodiments, the first sensing insulating layer may be directly on the encapsulation layer.

Aspects of some embodiments of the present disclosure include a method of manufacturing a display device. According to some embodiments, the method includes forming a preliminary first conductive layer on a first sensing insulating layer, etching a portion of the preliminary first conductive layer to form a first conductive layer including a first-first conductive portion and a first-second conductive portion, forming a preliminary second sensing insulating layer on the first conductive layer and the first sensing insulating layer, etching a portion of the preliminary second sensing insulating layer to form a second sensing insulating layer through which a first opening exposing at least a portion of the first-first conductive portion and a contact hole exposing a portion of the first-second conductive portion are defined, forming a preliminary second conductive layer on the first conductive layer, the first sensing insulating layer, and the second sensing insulating layer, etching a portion of the preliminary second conductive layer to form a second conductive layer including a second-first conductive portion electrically connected to the first-first conductive portion, a second-second conductive portion electrically connected to the first-second conductive portion, and a second-third conductive portion spaced apart from the first conductive layer in a plan view, forming a preliminary insulating pattern on the first sensing insulating layer and the second-first conductive portion, and etching a portion of the preliminary insulating pattern to form an insulating pattern on the second-first conductive portion. According to some embodiments, the insulating pattern is on the second-first conductive portion and in the first opening.

According to some embodiments, the insulating pattern includes at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

According to some embodiments, the method further includes forming a preliminary third conductive layer on the second-third conductive portion, the second-second conductive portion, the second sensing insulating layer, and the insulating pattern and etching a portion of the preliminary third conductive layer to form a third conductive layer including a third-third conductive portion directly on the second-third conductive portion, a third-second conductive portion directly on the second-second conductive portion, and a third-first conductive portion on the insulating pattern.

According to some embodiments, the third-third conductive portion has a size equal to or greater than a size of the second-third conductive portion in a plan view.

According to some embodiments, the method further includes forming a third sensing insulating layer on the third conductive layer.

According to some embodiments, the first-first conductive portion does not overlap the first-second conductive portion, and a sum of a thickness of the first-first conductive portion and a thickness of the second-first conductive portion is equal to or greater than 2000 angstroms and equal to or smaller than 37500 angstroms.

Aspects of some embodiments of the present disclosure include an electronic device including a case, a display device in the case, and a window on the display device. According to some embodiments, the display device includes a display panel including a plurality of light emitting areas and an input sensing panel including a first sensing insulating layer on the display panel, a second sensing insulating layer on the first sensing insulating layer and provided with a first opening and a contact hole, which are defined therethrough, an insulating pattern, and a plurality of conductive patterns. According to some embodiments, the conductive patterns include a first conductive layer and a second conductive layer, the first conductive layer includes a first-first conductive portion in the first opening and a first-second conductive portion partially exposed through the contact hole, the second conductive layer includes a second-first conductive portion electrically connected to the first-first conductive portion, a second-second conductive portion electrically connected to the first-second conductive portion, and a second-third conductive portion spaced apart from the first conductive layer in a plan view, and the insulating pattern is on the second-first conductive portion and in the first opening.

According to some embodiments of the present disclosure, a display device in an electronic device includes conductive patterns, and a thickness of the conductive patterns may be relatively increased, and thus, a resistance of the display device and the electronic device including the display device may be relatively improved.

According to some embodiments of the present disclosure, conductive patterns formed according to the method of manufacturing the display device may have relatively an increased thickness, and thus, the resistance may be relatively improved and difficulties in a manufacturing process may be relatively reduced.

### BRIEF DESCRIPTION OF THE DRAWINGS

The above and other aspects of some embodiments of the present disclosure will become readily apparent by reference to the following detailed description when considered in conjunction with the accompanying drawings wherein:
FIG. 1 is a perspective view of an electronic device according to some embodiments of the present disclosure;
FIG. 2 is a cross-sectional view taken along a line I-I' of FIG. 1;
FIG. 3 is a plan view of a display panel according to some embodiments of the present disclosure;
FIG. 4 is a cross-sectional view of a display module according to some embodiments of the present disclosure;
FIG. 5 is a plan view of an input sensing panel according to some embodiments of the present disclosure;
FIGS. 6A and 6B are enlarged plan views of portions of an input sensing panel of FIG. 5;
FIGS. 6C and 6D are enlarged plan views of portions of display areas according to some embodiments of the present disclosure;
FIG. 7 is a cross-sectional view taken along a line II-II' of FIG. 6A;
FIG. 8 is a cross-sectional view taken along a line III-III' of FIG. 6A;
FIG. 9 is a flowchart illustrating aspects of a method of manufacturing a display device according to some embodiments of the present disclosure; and
FIGS. 10 to 19 are cross-sectional views illustrating processes of a method of manufacturing a display device according to some embodiments of the present disclosure.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Meanwhile, in the present disclosure, when an element is referred to as being "directly connected" to another element, there are no intervening elements present between a layer, film region, or substrate and another layer, film, region, or substrate. For example, the term "directly connected" may mean that two layers or two members are arranged or formed without employing additional adhesive therebetween.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present disclosure will be described in more detail with reference to accompanying drawings.

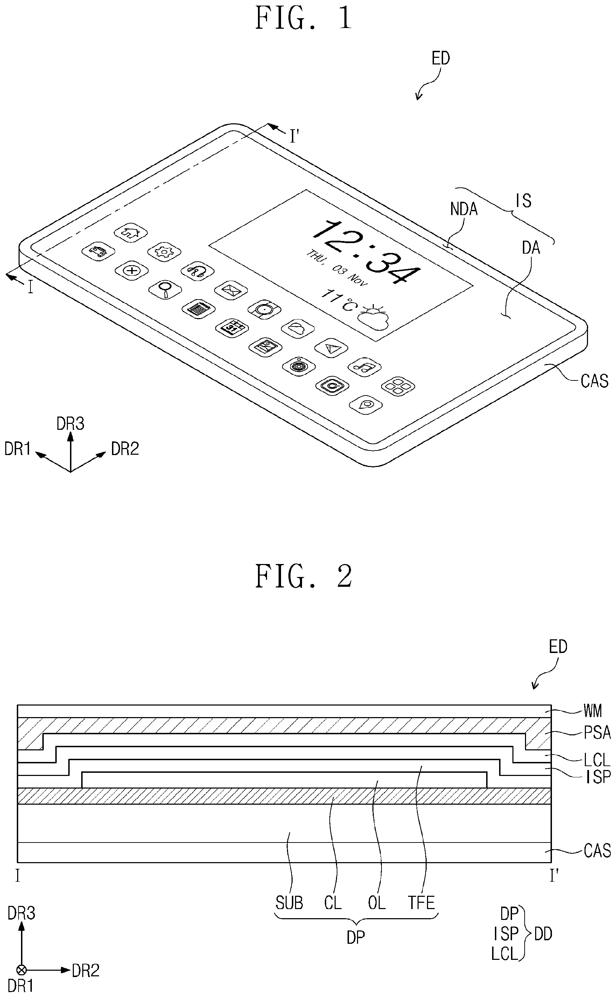

FIG. 1 is a perspective view of an electronic device ED according to some embodiments of the present disclosure. FIG. 1 shows the electronic device ED that is able to be applied to a tablet terminal as a representative example. FIG. 2 is a cross-sectional view taken along a line I-I' of FIG. 1. FIG. 2 shows a cross-section of the electronic device ED.

Referring to FIGS. 1 and 2, the electronic device ED may include a case CAS, a display device DD located in the case CAS, and a window WM located on the display device DD. The window WM may be coupled with the case CAS to form an exterior of the electronic device ED. According to some embodiments, the case CAS, the display device DD, and the window WM may be sequentially stacked in a third direction DR3. As shown in FIG. 1, a display surface IS may include an active area DA at which images are displayed and a bezel area NDA defined adjacent to (e.g., in a periphery or outside a footprint of) the active area DA. The image is not displayed through the bezel area NDA. FIG. 1 shows application icons as a representative example of the image.

As shown in FIG. 1, the active area DA may have a substantially quadrangular shape. In the present embodiments, the term "substantially quadrangular shape" as used herein may include not only a quadrangular shape in a mathematical concept but also a quadrangular shape in which vertices are not defined in a vertex area (or a corner area) and a curved boundary is defined at the vertex area.

The bezel area NDA may surround (e.g., in a periphery or outside a footprint of) the active area DA. However, embodiments according to the present disclosure are not limited thereto or thereby, and the shape of the bezel area NDA may be changed. For instance, the bezel area NDA may be located only at one side of the active area DA.

The window WM may include an optically transparent material. The window WM may include an insulating panel. For example, the window WM may include a glass material, a plastic material, or a combination thereof. A front surface of the window WM may define a front surface of the display device DD. The window WM may include an optically transparent area. As an example, the optically transparent area of the window WM may be an area having a visible light transmittance of 90% (or about 90%) or more.

The case CAS may accommodate the display device DD and may be coupled with the window WM. The case CAS may protect components, e.g., the display device DD, accommodated in the case CAS.

Electronic modules, a camera module, a power supply module, etc., which are mounted on a main board and provided in the case CAS, may constitute the tablet terminal with the display device DD, however, embodiments according to the present disclosure are not limited thereto or thereby. According to some embodiments, the electronic device ED may be applied to a large-sized electronic item, such as a television set and a monitor, and a small and medium-sized electronic item, such as a mobile phone, a car navigation unit, a game unit, and a smart watch.

The display device DD may be coupled with the window WM by an adhesive layer PSA, however, embodiments according to the present disclosure are not limited thereto or thereby. According to some embodiments, the adhesive layer PSA may be omitted. The window WM may be formed by a coating method, and the window WM may be located directly on the display device DD.

The display device DD may include a display panel DP and an input sensing panel ISP. The display device DD may further include a light control member LCL. The display panel DP may include a base substrate SUB, a circuit element layer CL, a display element layer OL, and a thin film encapsulation layer TFE.

The base substrate SUB may be a flexible substrate that is bendable, foldable, or rollable. The base substrate SUB may be a glass substrate, a metal substrate, or a polymer substrate, however, the present disclosure should not be limited thereto or thereby. The base substrate SUB may be an inorganic layer, an organic layer, or a composite material layer. The base substrate SUB may have substantially the same shape as the display panel DP.

The base substrate SUB may have a multi-layer structure. For instance, the base substrate SUB may include a first synthetic resin layer, a second synthetic resin layer, and inorganic layers located between the first and second synthetic resin layers. Each of the first and second synthetic resin layers may include a polyimide-based resin, however, it should not be particularly limited.

The circuit element layer CL may be located on the base substrate SUB. The circuit element layer CL may include a plurality of insulating layers, a plurality of semiconductor patterns, a plurality of conductive patterns, and signal lines. The circuit element layer CL may include a driving circuit for a pixel.

The display element layer OL may be located on the circuit element layer CL. The display element layer OL may include a light emitting element. As an example, the light emitting element may include an organic light emitting material, an inorganic light emitting material, an organic-inorganic light emitting material, a quantum dot, a quantum rod, a micro-LED, or a nano-LED.

The thin film encapsulation layer TFE may be located on the display element layer OL. The thin film encapsulation layer TFE may protect the display element layer OL from moisture, oxygen, and a foreign substance such as dust particles. The thin film encapsulation layer TFE may include at least one inorganic layer. The thin film encapsulation layer TFE may include a stack structure of a first encapsulation inorganic layer/an encapsulation organic layer/a second encapsulation inorganic layer.

The input sensing panel ISP may be located directly on the display panel DP. The input sensing panel ISP may sense a user input by an electromagnetic induction method and/or a capacitive method. The display panel DP and the input sensing panel ISP may be formed through successive processes. In the present disclosure, the expression "The input sensing panel ISP is located directly on the display panel DP." may mean that no intervening elements are present between the input sensing panel ISP and the display panel DP. As an example, a separate adhesive layer may not be located between the input sensing panel ISP and the display panel DP.

The light control member LCL may be a reflection reduction layer that decreases a reflectance of the display device DD with respect to an external light incident to the display device DD, however, the present disclosure should not be limited thereto or thereby. As an example, the light control member LCL may include various components for a light control layer to improve a display quality of the display device DD. As an example, the light control member LCL may include a polarizing layer, a retarder, a destructive interference structure, or a plurality of color filters. Meanwhile, the light control member LCL may be omitted.

The window WM may include a base structure and a light blocking pattern. The base structure may include a glass substrate and/or a synthetic resin film. The light blocking pattern may partially overlap the base structure. The light blocking pattern may substantially correspond to the bezel area NDA of the electronic device ED. An area in which the light blocking pattern is not located may correspond to the active area DA of the electronic device ED. In the present disclosure, the expression "An area/portion corresponds to another area/portion." means that "An area/portion overlaps another area/portion.", but the expression should not be limited to "An area/portion has the same area and/or the same shape as another area/portion."

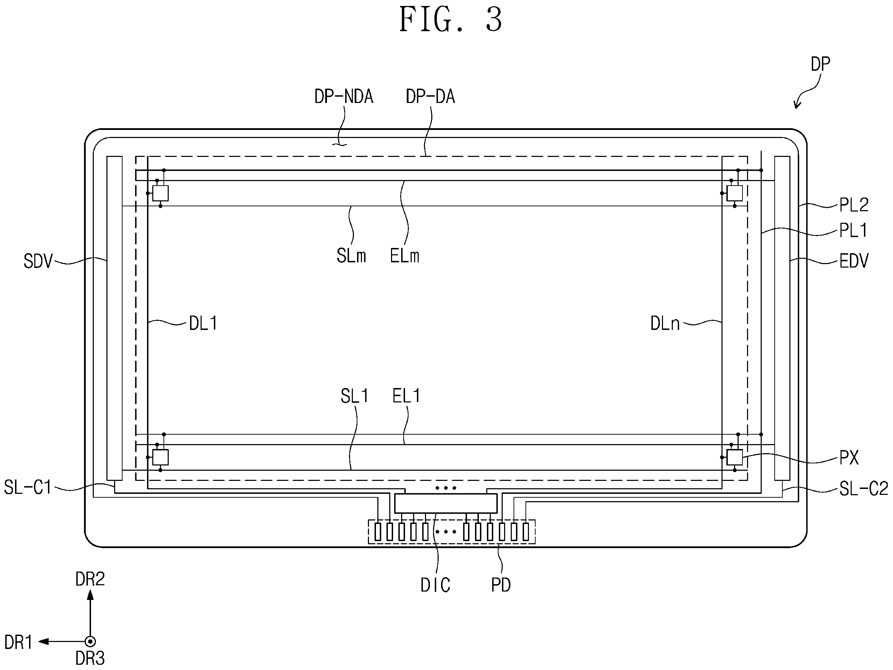

FIG. 3 is a plan view of the display panel DP according to some embodiments of the present disclosure.

Referring to FIG. 3, the display panel DP may include a plurality of pixels PX, a scan driver SDV, an emission driver EDV, a plurality of signal lines, and a plurality of pads PD. The pixels PX may be arranged in a display area DP-DA. A driving chip DIC mounted in a non-display area DP-NDA may include a data driver. The display area DP-DA may correspond to the active area DA of the electronic device ED, and the non-display area DP-NDA may correspond to the bezel area NDA. In addition, the data driver may be integrated in the display panel DP together with the scan driver SDV and the emission driver EDV.

The display panel DP may include a plurality of scan lines SL1 to SLm, a plurality of data lines DL1 to DLn, a plurality of emission lines EL1 to ELm, first and second control lines SL-C1 and SL-C2, and first and second power lines PL1 and PL2. Each of "m" and "n" is a natural number greater than 0.

The scan lines SL1 to SLm may extend in a direction parallel to a second direction DR2 and may be connected to the pixels PX and the scan driver SDV. The data lines DL1 to DLn may extend in a direction parallel to a first direction DR1 and may be connected to the driving chip DIC. The emission lines EL1 to ELm may extend in the direction parallel to the second direction DR2 and may be connected to the pixels PX and the emission driver EDV.

The first power line PL1 may receive a first power voltage, and the second power line PL2 may receive a second power voltage lower than the first power voltage. According to some embodiments, a second electrode, e.g., a cathode, of the light emitting element may be connected to the second power line PL2.

The first control line SL-C1 may be connected to the scan driver SDV and may extend toward a lower end of the display panel DP. The second control line SL-C2 may be connected to the emission driver EDV and may extend toward the lower end of the display panel DP. The pads PD may be located in the non-display area DP-NDA adjacent to the lower end of the display panel DP and may be located closer to the lower end of the display panel DP than the driving chip DIC is. The pads PD may be connected to the driving chip DIC and some of the signal lines.

The scan driver SDV may generate a plurality of scan signals, and the scan signals may be applied to the pixels PX via the scan lines SL1 to SLm. The driving chip DIC may generate a plurality of data voltages, and the data voltages may be applied to the pixels PX via the data lines DL1 to DLn. The emission driver EDV may generate a plurality of emission signals, and the emission signals may be applied to the pixels PX via the emission lines EL1 to ELm. The pixels PX may receive the data voltages in response to the scan signals. The pixels PX may emit a light having a luminance corresponding to the data voltages in response to the emission signals, and thus, the image may be displayed.

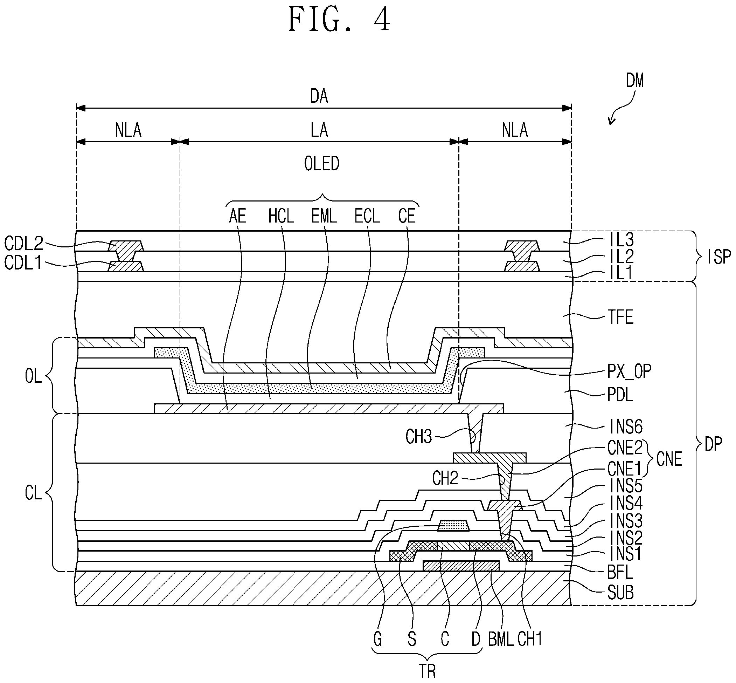

FIG. 4 is a cross-sectional view of a display module DM according to some embodiments of the present disclosure. FIG. 4 shows a cross-section of the display module DM corresponding to one pixel PX.

Referring to FIG. 4, the display module DM may include the display panel DP and the input sensing panel ISP.

The display panel DP may include the pixels PX (refer to FIG. 3). Each pixel PX (refer to FIG. 3) may include a transistor TR and a light emitting element OLED. The transistor TR and the light emitting element OLED may be located on the base substrate SUB. As an example, one transistor TR is shown in FIG. 4, however, the pixel PX (refer to FIG. 3) may include a plurality of transistors and at least one capacitor to drive the light emitting element OLED.

The circuit element layer CL may be located on the base substrate SUB. The circuit element layer CL may include a light shielding electrode BML, the transistor TR, connection electrodes CNE, and a plurality of insulating layers BFL and INS1 to INS6. The insulating layers BFL and INS1 to INS6 may include a buffer layer BFL and first, second, third, fourth, fifth, and sixth insulating layers INS1, INS2, INS3, INS4, INS5, and INS6. However, the cross-section of the circuit element layer CL shown in FIG. 4 is merely an example, and the stack structure of the circuit element layer CL may be changed in various ways depending on the configuration of the pixel PX (refer to FIG. 3) and the processes of the circuit element layer CL.

The light shielding electrode BML may be located on the base substrate SUB. The light shielding electrode BML may overlap the transistor TR. The light shielding electrode BML may block a light entering the transistor TR from a lower side of the display panel DP to protect the transistor TR. The light shielding electrode BML may include a conductive material. The light shielding electrode BML may be connected to the power lines PL1 and PL2 (refer to FIG. 3) and may receive a voltage. When the voltage is applied to the light shielding electrode BML, a threshold voltage of the transistor TR located on the light shielding electrode BML may be maintained, however, embodiments according to the present disclosure are not limited thereto or thereby. According to some embodiments, the light shielding electrode BML may be a floating electrode. According to some embodiments, the light shielding electrode BML may be omitted.

The buffer layer BFL may be located on the base substrate SUB to cover the light shielding electrode BML. The buffer layer BFL may be an inorganic layer. The buffer layer BFL may improve an adhesive force between the semiconductor pattern located on the buffer layer BFL and the base substrate SUB or between the conductive pattern located on the butter laye BFL and the base substrate SUB.

The transistor TR may include a source S, a channel C, a drain D, and a gate G. The source S, the channel C, and the drain D of the transistor TR may be formed from the semiconductor pattern. The semiconductor pattern of the transistor TR may include polysilicon, amorphous silicon, or a metal oxide and should not be particularly limited as long as a material for the transistor TR has a semiconductor property.

The semiconductor pattern may include a plurality of areas distinguished from each other depending on a level of conductivity. A portion of the semiconductor pattern, which is doped with a dopant, or a portion of the semiconductor pattern, where a metal oxide is reduced, may have a relatively high conductivity and may serve as the source S and the drain D of the transistor TR. The portion of the semiconductor pattern, which has a relatively high conductivity, may correspond to the source S and the drain D of the transistor TR. A non-doped portion, a portion doped at low-concentration, or a portion where the metal oxide is not reduced, which is provided with a relatively low conductivity, may correspond to the channel C (or an active) of the transistor TR.

A first insulating layer INS1 may be located on the buffer layer BFL and may cover the semiconductor pattern of the transistor TR. The gate G of the transistor TR may be located on the first insulating layer INS1. The gate G may overlap the channel C of the transistor TR. The gate G may be used as a mask in a process of doping the semiconductor pattern of the transistor TR.

The second insulating layer INS2 may be located on the first insulating layer INS1 and may cover the gate G. The third insulating layer INS3 may be located on the second insulating layer INS2.

The connection electrodes CNE may include a first connection electrode CNE1 and a second connection electrode CNE2 to electrically connect the transistor TR and the light emitting element OLED. However, the connection electrodes CNE that connect the transistor TR and the light emitting element OLED should not be limited thereto or thereby. According to some embodiments, one of the first and second connection electrodes CNE1 and CNE2 may be omitted, or the connection electrodes CNE may further include an additional connection electrode.

The first connection electrode CNE1 may be located on the third insulating layer INS3. The first connection electrode CNE1 may be connected to the drain D via a first contact hole CH1 defined through the first to third insulating layers INS1 to INS3. The fourth insulating layer INS4 may be located on the third insulating layer INS3 and may cover the first connection electrode CNE1. The fifth insulating layer INS5 may be located on the fourth insulating layer INS4.

The second connection electrode CNE2 may be located on the fifth insulating layer INS5. The second connection electrode CNE2 may be connected to the first connection electrode CNE1 via a second contact hole CH2 defined through the fourth and fifth insulating layers INS4 and INS5. The sixth insulating layer INS6 may be located on the fifth insulating layer INS5 and may cover the second connection electrode CNE2.

Each of the first to sixth insulating layers INS1 to INS6 may include an inorganic layer or an organic layer. As an example, the inorganic layer may include at least one of aluminum oxide, titanium oxide, silicon oxide, silicon nitride, silicon oxynitride, zirconium oxide, or hafnium oxide. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

The display element layer OL may include a pixel definition layer PDL and the light emitting element OLED. The light emitting element OLED may include a first electrode AE, a hole control layer HCL, an electron control layer ECL, a light emitting layer EML, and a second electrode CE.

The first electrode AE may be located on the sixth insulating layer INS6. The first electrode AE may be connected to the second connection electrode CNE2 via a third contact hole CH3 defined through the sixth insulating layer INS6. The first electrode AE may be connected to the drain D of the transistor TR through the first and second connection electrodes CNE1 and CNE2.

The pixel definition layer PDL may be located on the sixth insulating layer INS6. A light emitting opening PX_OP may be defined through the pixel definition layer PDL to expose a portion of the first electrode AE. The portion of the first electrode AE exposed through the light emitting opening PX_OP may correspond to a light emitting area LA.

An area in which the pixel definition layer PDL is located may correspond to a non-light-emitting area NLA. The non-light-emitting area NLA may surround the light emitting area LA in the display area DA.

The hole control layer HCL may be located on the first electrode AE and the pixel definition layer PDL. The hole control layer HCL may be provided as a common layer that overlaps the light emitting area LA and the non-light-emitting area NLA. The hole control layer HCL may include at least one of a hole transport layer, a hole injection layer, or an electron block layer.

The light emitting layer EML may be located on the hole control layer HCL. The light emitting layer EML may be located in an area corresponding to the light emitting opening PX_OP, however, the present disclosure should not be limited thereto or thereby. The light emitting layer EML may be provided as a common layer. The light emitting layer EML may include an organic material and/or an inorganic material. The light emitting layer EML may emit a light having one of red, green, and blue colors.

The electron control layer ECL may be located on the light emitting layer EML. The electron control layer ECL may be provided as a common layer that overlaps the light emitting area LA and the non-light-emitting area NLA. The electron control layer ECL may include at least one of an electron transport layer, an electron injection layer, or a hole block layer.

The second electrode CE may be located on the electron control layer ECL. The second electrode CE may be provided as a common layer that overlaps the light emitting area LA and the non-light-emitting area NLA. The second electrode CE may be commonly arranged in the pixels PX (refer to FIG. 3) and may apply a voltage to the pixels PX (refer to FIG. 3).

The thin film encapsulation layer TFE may be located on the second electrode CE to cover the light emitting element OLED. The thin film encapsulation layer TFE may include a plurality of thin layers. As an example, the thin film encapsulation layer TFE may include inorganic layers located on the second electrode CE and an organic layer located between the inorganic layers. The inorganic layer of the thin film encapsulation layer TFE may protect the light emitting element OLED from moisture and oxygen, and the organic layer may protect the light emitting element OLED from a foreign substance such as dust particles, however, the present disclosure should not be particularly limited.

A first voltage may be applied to the first electrode AE via the transistor TR, and a second voltage having a voltage level lower than that of the first voltage may be applied to the second electrode CE. Holes and electrons injected into the light emitting layer EML may be recombined to generate excitons, and the light emitting element OLED may emit the light by the excitons that return to a ground state from an excited state.

The input sensing panel ISP may include a first sensing insulating layer IL1, a second sensing insulating layer IL2, and a third sensing insulating layer IL3. The input sensing panel ISP may include at least one conductive layer located on the sensing insulating layers. The input sensing panel ISP may include a first conductive layer CDL1 and a second conductive layer CDL2.

The first sensing insulating layer IL1 may be located on the thin film encapsulation layer TFE. The first sensing insulating layer IL1 may include at least one inorganic insulating layer. The first sensing insulating layer IL1 may be in contact with the thin film encapsulation layer TFE, however, the present disclosure should not be limited thereto or thereby. According to some embodiments, the first sensing insulating layer IL1 may be omitted, and in this case, the first conductive layer CDL1 may be in contact with the thin film encapsulation layer TFE.

The first conductive layer CDL1 may be located on the first sensing insulating layer IL1. The first conductive layer CDL1 may include a plurality of first conductive patterns. The first conductive patterns may be located on the first sensing insulating layer IL1.

The second sensing insulating layer IL2 may be located on the first sensing insulating layer IL1 to cover the first conductive layer CDL1.

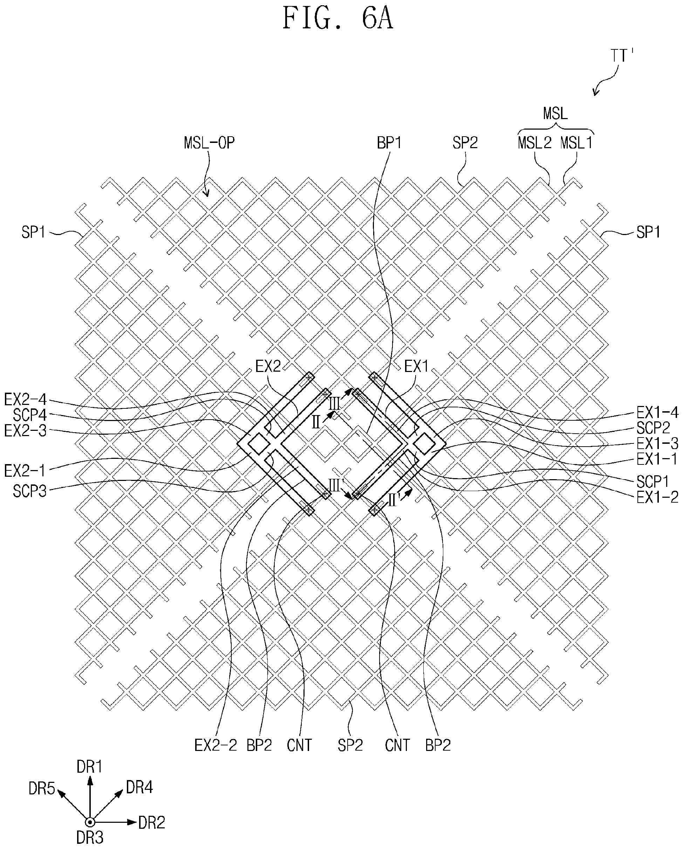

The second conductive layer CDL2 may be located on the second sensing insulating layer IL2. The second conductive layer CDL2 may include a plurality of second conductive patterns. The second conductive patterns may be located on the second sensing insulating layer IL2. The second conductive patterns may be connected to the first conductive patterns via a contact hole CNT (refer to FIG. 6A) defined through the second sensing insulating layer IL2.

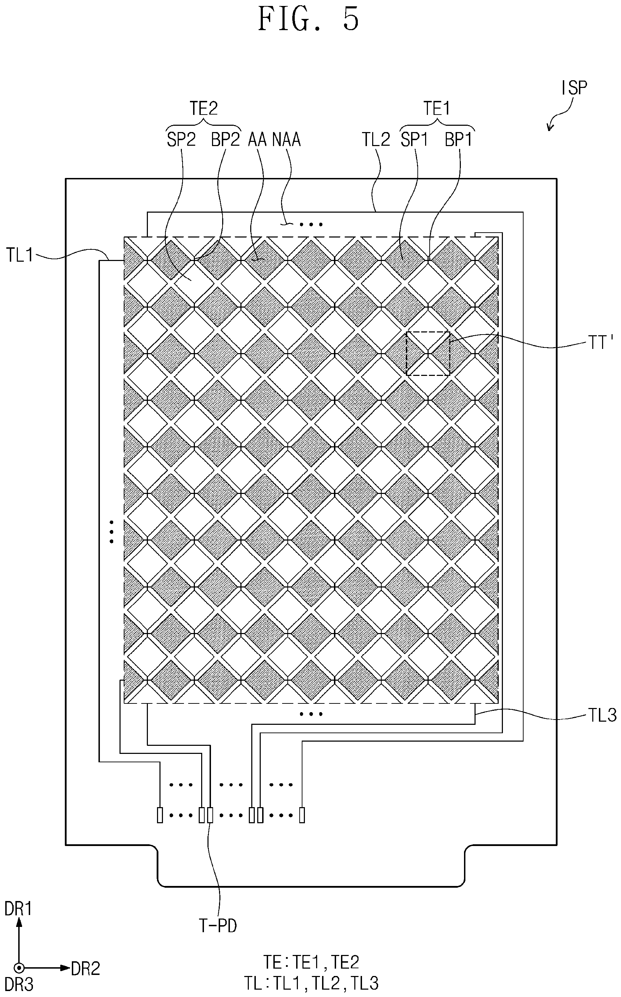

Each of the first conductive patterns of the first conductive layer CDL1 and the second conductive patterns of the second conductive layer CDL2 may be arranged corresponding to the non-light-emitting area NLA. Each of the first conductive patterns of the first conductive layer CDL1 and the second conductive patterns of the second conductive layer CDL2 may correspond to at least a portion of each of mesh lines MSL1 and MSL2 (refer to FIG. 6A). Each of the first conductive patterns of the first conductive layer CDL1 and the second conductive patterns of the second conductive layer CDL2 may include a plurality of sensing patterns SP1 and SP2 (refer to FIG. 5) described in more detail later.

The third sensing insulating layer IL3 may be located on the second sensing insulating layer IL2 and may cover the second conductive layer CDL2. The second sensing insulating layer IL2 and the third sensing insulating layer IL3 may include an inorganic insulating layer or an organic insulating layer.

FIG. 5 is a plan view of the input sensing panel ISP according to some embodiments of the present disclosure.

The input sensing panel ISP may include an active area AA and a peripheral area NAA defined adjacent to the active area AA.

The active area AA may correspond to the active area DA (refer to FIG. 1) of the electronic device ED (refer to FIG. 1). Sensing electrodes TE of the input sensing panel ISP may be located in the active area AA and may sense the external input.

The peripheral area NAA may correspond to the bezel area NDA (refer to FIG. 1) of the electronic device ED (refer to FIG. 1). Elements and lines may be located in the peripheral area NAA to drive the sensing electrodes TE located in the active area AA.

The input sensing panel ISP may include the sensing electrodes TE, trace lines TL, and sensing pads T-PD.

The sensing electrodes TE may be located in the active area AA. The sensing electrodes TE may include first sensing electrodes TE1 and second sensing electrodes TE2 electrically insulated from the first sensing electrodes TE1 while intersecting the first sensing electrodes TE1 when viewed in the plane (e.g., in a plan view). The input sensing panel ISP may obtain information about the external input based on a variation in mutual capacitance between the first sensing electrodes TE1 and the second sensing electrodes TE2.

Each of the first sensing electrodes TE1 may extend in the second direction DR2, and the first sensing electrodes TE1 may be arranged in the first direction DR1. The first sensing electrodes TE1 may be arranged in a plurality of rows arranged in the first direction DR1. FIG. 5 shows ten first sensing electrodes TE1 arranged in the first direction DR1 as a representative example, however, the number of the first sensing electrodes TE1 included in the input sensing panel ISP should not be limited thereto or thereby.

Each of the second sensing electrodes TE2 may extend in the first direction DR1, and the second sensing electrodes TE2 may be arranged in the second direction DR2. The second sensing electrodes TE2 may be arranged in a plurality of columns arranged in the second direction DR2. FIG. 5 shows eight second sensing electrodes TE2 arranged in the second direction DR2 as a representative example, however, the number of the second sensing electrodes TE2 included in the input sensing panel ISP should not be limited thereto or thereby.

Each of the first sensing electrodes TE1 may include first sensing patterns SP1 and first connection patterns BP1. The first sensing patterns SP1 may be arranged in the second direction DR2. The first connection patterns BP1 may connect the first sensing patterns SP1 adjacent to each other in the second direction DR2. The first connection patterns BP1 may be located on the same layer as the first sensing patterns SP1, may extend from the first sensing patterns SP1 when viewed in the plane (e.g., in a plan view), and may be provided integrally with the first sensing patterns SP1. The first sensing patterns SP1 and the first connection patterns BP1 may be formed of the same conductive layer by patterning the conductive layer through the same process. However, the first connection patterns BP1 should not be particularly limited as long as the first connection patterns BP1 electrically connect the first sensing patterns SP1 adjacent to each other in the second direction DR2.

Each of the second sensing electrodes TE2 may include second sensing patterns SP2 and second connection patterns BP2. The second sensing patterns SP2 may be arranged in the first direction DR1. The second connection patterns BP2 may connect the second sensing patterns SP2 adjacent to each other in the first direction DR1. The second connection patterns BP2 may be located on a different layer from the second sensing patterns SP2 and may be connected to corresponding second sensing patterns SP2 through the contact holes CNT (refer to FIG. 6A). The second sensing patterns SP2 spaced apart from each other in the first direction DR1 may be electrically connected to each other through the second connection patterns BP2. The second connection patterns BP2 located on a different layer from the second sensing patterns SP2 and electrically connecting the second sensing patterns SP2 may be defined as bridge patterns.

According to some embodiments, the first sensing patterns SP1, the first connection patterns BP1, and the second sensing patterns SP2 may be located on the same layer. The second connection patterns BP2 and the second sensing patterns SP2 may be located on different layers from each other. As an example, the first sensing patterns SP1, the first connection patterns BP1, and the second sensing patterns SP2 may be included in the second conductive layer CDL2 (refer to FIG. 4), and the second connection patterns BP2 may be included in the first conductive layer CDL1 (refer to FIG. 4).

However, embodiments according to the present disclosure are not limited thereto or thereby. According to some embodiments, the first sensing patterns SP1, the first connection patterns BP1, and the second sensing patterns SP2 may be included in the first conductive layer CDL1, and the second connection patterns BP2 may be included in the second conductive layer CDL2. According to some embodiments, the first sensing patterns SP1, the second sensing patterns SP2, and the second connection patterns BP2 may be located on the same layer, and the first connection patterns BP1 and the first sensing patterns SP1 may be located on different layers from each other.

The trace lines TL may include first trace lines TL1, second trace lines TL2, and third trace lines TL3.

Each of the first trace lines TL1 may be connected to the first sensing electrodes TE1. Each of the first trace lines TL1 may be connected to the first sensing electrodes TE1 arranged in a corresponding row among the first sensing electrodes TE1 arranged in the plural rows.

The first trace lines TL1 may be connected to left or right ends of the first sensing electrodes TE1. FIG. 5 shows the structure in which the first trace lines TL1 are connected to the left ends of the first sensing electrodes TE1 as a representative example. However, the connection of the first trace lines TL1 to the first sensing electrodes TE1 should not be limited thereto or thereby.

Each of the first trace lines TL1 may extend downward from a corresponding first sensing electrode TE1 in the peripheral area NAA, and the first trace lines TL1 may be respectively connected to the sensing pads T-PD in the peripheral area NAA.

The second trace lines TL2 may be respectively connected to upper ends of the second sensing electrodes TE2. The second trace lines TL2 may be respectively connected to the upper ends of the second sensing electrodes TE2 arranged in a corresponding column among the second sensing electrodes TE2 arranged in the plural columns. Each of the second trace lines TL2 may extend from an upper end of a corresponding second sensing electrode TE2 in the peripheral area NAA, and the second trace lines TL2 may be respectively connected to the sensing pads T-PD in the peripheral area NAA.

The third trace lines TL3 may be respectively connected to lower ends of the second sensing electrodes TE2. The third trace lines TL3 may be respectively connected to the lower ends of the second sensing electrodes TE2 arranged in a corresponding column among the second sensing electrodes TE2 arranged in the plural columns. Each of the third trace lines TL3 may extend from a lower end of a corresponding second sensing electrode TE2 in the peripheral area NAA, and the third trace lines TL3 may be respectively connected to the sensing pads T-PD in the peripheral area NAA.

According to some embodiments, a length in the first direction DR1 of the second sensing electrode TE2 may be greater than a length in the second direction DR2 of the first sensing electrode TE1. However, since the second sensing electrode TE2 is connected to the second trace line TL2 and the third trace line TL3, the second sensing electrode TE2 having a relatively longer length than that of the first sensing electrode TE1 may have uniform sensitivity across the entire area thereof.

The sensing pads T-PD may be arranged adjacent to a lower end of active area AA in the peripheral area NAA. The sensing pads T-PD may be arranged spaced apart from each other.

The sensing pads T-PD may be electrically connected to a circuit board that provides a driving signal. The sensing pads T-PD may be electrically connected to the trace lines TL, respectively. The sensing pads T-PD may apply signals to the sensing electrodes TE via the trace lines TL. The sensing pads T-PD may receive signals from the sensing electrodes TE.

The sensing pads T-PD may be provided integrally with the trace lines TL connected thereto. That is, different from the sensing pads T-PD and the trace lines TL shown in FIG. 5, the sensing pads T-PD and the trace lines TL may not be distinguished from each other, and an end of the trace lines TL may serve as a sensing pad portion that is connected to a driving chip of the circuit board.

The sensing pads T-PD and the trace lines TL may be formed from the conductive layer CDL1, CDL2 (refer to FIG. 4) of the input sensing panel ISP. As an example, the sensing pads T-PD and the trace lines TL may be formed through the same process as the first conductive layer CDL1, however, the present disclosure should not be limited thereto or thereby. Depending on locations where the sensing electrodes TE are placed, the sensing pads T-PD and the trace lines TL may be formed through the same process as the second conductive layer CDL2, or some of the sensing pads T-PD and some of the trace lines TL may be formed through the same process as the first conductive layer CDL1 and some of the sensing pads T-PD and some of the trace lines TL may be formed through the same process as the second conductive layer CDL2.

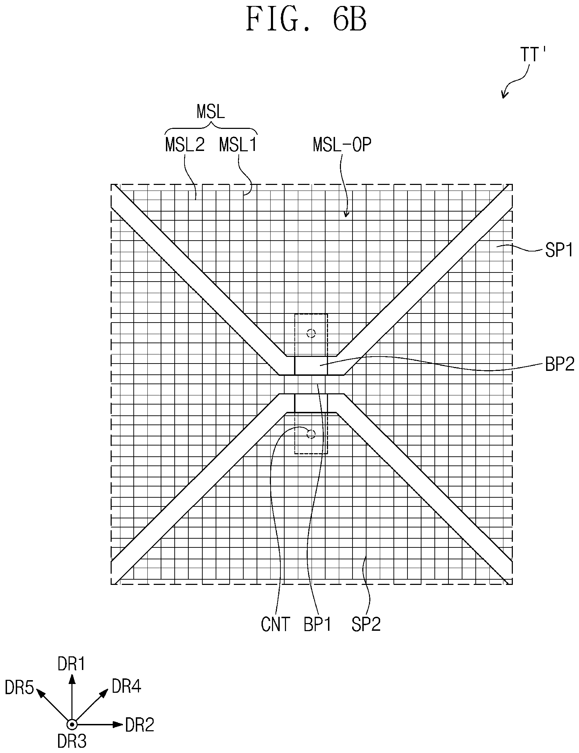

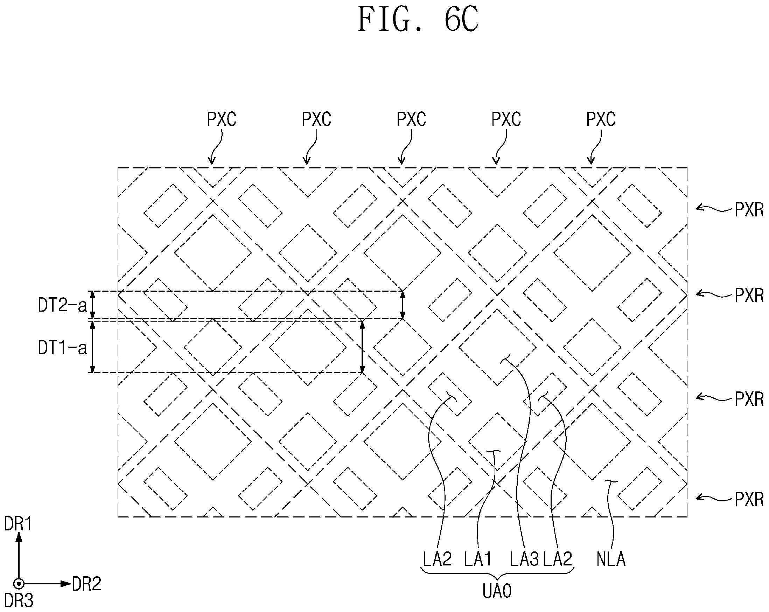

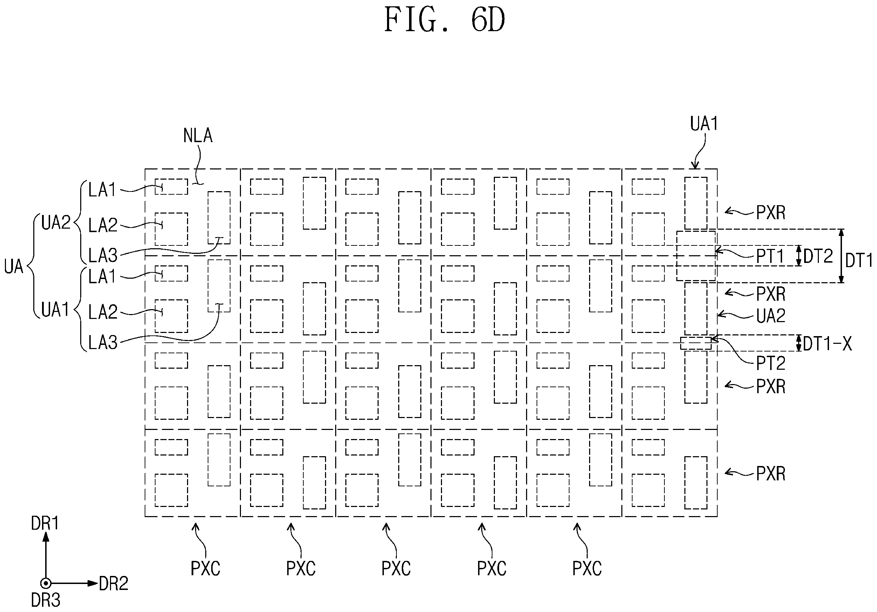

FIGS. 6A and 6B are enlarged plan views of a portion TT' of the input sensing panel ISP of FIG. 5. FIGS. 6C and 6D are enlarged plan views of portions of display areas according to embodiments of the present disclosure. FIGS. 6A and 6B are enlarged view of the portion TT' of FIG. 5.

FIG. 6A shows an arrangement relationship between the first sensing patterns SP1, the first connection patterns BP1, the second sensing patterns SP2, and the second connection patterns BP2 when viewed in the plane (e.g., in a plan view), and for the convenience of explanation, the sensing insulating layers IL1, IL2, and IL3 (refer to FIG. 4) are omitted.

According to some embodiments, the second sensing patterns SP2 and the first sensing electrodes TE1 (refer to FIG. 5) may include mesh lines MSL. The mesh lines MSL may include a first mesh line MSL1 extending in a fourth direction DR4 and a second mesh line MSL2 extending in a fifth direction DR5.

The first and second mesh lines MSL1 and MSL2 may not overlap the light emitting area LA described with reference to FIG. 4 and may overlap the non-light-emitting area NLA described with reference to FIG. 4. The first and second mesh lines MSL1 and MSL2 may define a plurality of mesh openings MSL-OP. The first and second mesh lines MSL1 and MSL2 may have a line width of several nanometers to several micrometers. The mesh openings MSL-OP may correspond to the light emitting areas LA (refer to FIG. 4) defined in each pixel PX in a one-to-one correspondence.

According to some embodiments, the second sensing patterns SP2 and the first sensing electrodes TE1 may be portions of the second conductive layer CDL2 described with reference to FIG. 4.

The first sensing electrodes TE1 (refer to FIG. 5) may include the first sensing patterns SP1 and the first connection patterns BP1 extending from the first sensing patterns SP1 and provided integrally with the first sensing patterns SP1. That is, the first sensing patterns SP1 and the first connection patterns BP1 may be provided integrally with each other after being pattered through the same process, however, for the convenience of explanation, they will be described separately.

The second sensing electrodes TE2 (refer to FIG. 5) may include the second sensing patterns SP2 and the second connection patterns BP2 connecting the second sensing patterns SP2 adjacent to each other. The first sensing patterns SP1, the first connection patterns BP1, and the second sensing patterns SP2 may be located on the same layer. The second connection patterns BP2 may be located on a different layer from the second sensing patterns SP2. However, the second connection patterns BP2 may be connected to the second sensing patterns SP2 via the contact hole CNT.

The second connection pattern BP2 may include a first extension portion EX1 and a second extension portion EX2 having a shape symmetrical with the first extension portion EX1. The first connection pattern BP1 may be located between the first extension portion EX1 and the second extension portion EX2.

The first extension portion EX1 and the second extension portion EX2 may extend via an area of the first sensing pattern SP1 overlapping one second connection pattern BP2 and may be connected to the second sensing pattern SP2.

Hereinafter, based on a relative position of the second sensing pattern SP2, the second sensing pattern SP2 may be defined as an upper second sensing pattern SP2 and a lower second sensing pattern SP2. In addition, based on a relative position of the first sensing pattern SP1, the first sensing pattern SP1 may be defined as a left first sensing pattern SP1 and a right first sensing pattern SP1.

Predetermined portions of the first and second extension portions EX1 and EX2, which are adjacent to one sides of the first and second extension portions EX1 and EX2, may be connected to the lower second sensing pattern SP2 via the contact holes CNT. Predetermined portions of the first and second extension portions EX1 and EX2, which are adjacent to the other sides of the first and second extension portions EX1 and EX2, may be connected to the upper second sensing pattern SP2 via the contact holes CNT.

The first extension portion EX1 may include a first sub-extension portion EX1-1, a second sub-extension portion EX1-2, and a second sub-conductive pattern SCP2, which extend in the fourth direction DR4, and a third sub-extension portion EX1-3, a fourth sub-extension portion EX1-4, and a first sub-conductive pattern SCP1, which extend in the fifth direction DR5.

Predetermined portions of the first and second sub-extension portions EX1-1 and EX1-2, which are adjacent to one sides of the first and second sub-extension portions EX1-1 and EX1-2, may be connected to the lower second sensing pattern SP2 via the contact holes CNT. Predetermined portions of the third and fourth sub-extension portions EX1-3 and EX1-4, which are adjacent to one sides of the third and fourth sub-extension portions EX1-3 and EX1-4, may be connected to the upper second sensing pattern SP2 via the contact holes CNT.

The other side of the first sub-extension portion EX1-1 may extend from the other side of the third sub-extension portion EX1-3, and the other side of the second sub-extension portion EX1-2 may extend from the other side of the fourth sub-extension portion EX1-4. The first sub-conductive pattern SCP1 may extend from the other side of the fourth sub-extension portion EX1-4 to a direction opposite to the fifth direction DR5 and may extend to the first sub-extension portion EX1-1. The second sub-conductive pattern SCP2 may extend from the other side of the second sub-extension portion EX1-2 to the fourth direction DR4 and may extend to the third sub-extension portion EX1-3.

The first sub-extension portion EX1-1, the second sub-extension portion EX1-2, the third sub-extension portion EX1-3, the fourth sub-extension portion EX1-4, the first sub-conductive pattern SCP1, and the second sub-conductive pattern SCP2 may be integrally formed with each other.

The first and second sub-extension portions EX1-1 and EX1-2 may extend along the first mesh line MSL1 of the right first sensing pattern SP1 to cross some second mesh lines MSL2 adjacent to the lower second sensing pattern SP2. The mesh lines MSL1 and MSL2 may not be located in some areas overlapping the first and second sub-extension portions EX1-1 and EX1-2 and the second sub-conductive pattern SCP2.

The third and fourth sub-extension portions EX1-3 and EX1-4 may extend along the second mesh line MSL2 of the right first sensing pattern SP1 to cross some first mesh lines MSL1 adjacent to the upper second sensing pattern SP2. The mesh lines MSL1 and MSL2 may not be located in some areas overlapping the third and fourth sub-extension portions EX1-3 and EX1-4 and the first sub-conductive pattern SCP1.

The second extension portion EX2 may include a fifth sub-extension portion EX2-1 and a sixth sub-extension portion EX2-2, which extend in the fifth direction DR5, a seventh sub-extension portion EX2-3 and an eighth sub-extension portion EX2-4, which extend in the fourth direction DR4, a third sub-conductive pattern SCP3 extending in the fourth direction DR4, and a fourth sub-conductive pattern SCP4 extending in the fifth direction DR5.

The left first sensing pattern SP1 may have a structure symmetrical with that of the right first sensing pattern SP1, and the second extension portion EX2 may have a structure symmetrical with that of the first extension portion EX1. That is, descriptions on the first, second, third, and fourth sub-extension portions EX1-1, EX1-2, EX1-3, and EX1-4 may be equally applied to the fifth, sixth, seventh, and eighth sub-extension portions EX2-1, EX2-2, EX2-3, and EX2-4, and descriptions of the first and second sub-conductive patterns SCP1 and SCP2 may be equally applied to the third and fourth sub-conductive patterns SCP3 and SCP4.

Hereinafter, detailed descriptions of the components described with reference to FIG. 6A are omitted.

Referring to FIG. 6B, a mesh line MSL may include a first mesh line MSL1 and a second mesh line MSL2. The first mesh line MSL1 may extend in the first direction DR1. The second mesh line MSL2 may extend in the second direction DR2. Each of the first and second mesh lines MSL1 and MSL2 may be provided in plural, and the first mesh lines MSL1 may intersect the second mesh lines MSL2 to define a plurality of opening areas MSL-OP.

The first mesh lines MSL1 may be arranged spaced apart from each other in the second direction DR2. The second mesh lines MSL2 may be arranged spaced apart from each other in the first direction DR1. The second mesh lines MSL2 may intersect the first mesh lines MSL1 when viewed in the plane (e.g., in a plan view) and may be provided integrally with the first mesh lines MSL1.

The shape of the mesh line MSL shown in FIG. 6B is merely an example, and the arrangement and shape of the first and second mesh lines MSL1 and MSL2 and the opening areas MSL-OP in the mesh line MSL may be changed in various ways depending on the arrangement and shape of the pixels PX (refer to FIG. 3) of the display panel DP (refer to FIG. 3).

Referring to FIGS. 6C and 6D, the display area DP-DA (refer to FIG. 3) may include a plurality of light emitting areas LA1, LA2, and LA3 and the non-light-emitting area NLA adjacent to the light emitting areas LA1, LA2, and LA3. The non-light-emitting area NLA may define a boundary of the light emitting areas LA1, LA2, and LA3.

The light emitting areas LA1, LA2, and LA3 may be arranged in a one-to-one correspondence with the pixels PX of FIG. 3. Each of the pixels PX may include the light emitting element, and the light emitting areas LA1, LA2, and LA3 may be areas from which the light emitted from the light emitting element exits. The light emitting areas LA1, LA2, and LA3 may be defined by the pixel definition layer PDL (refer to FIG. 4).

The light emitting areas LA1, LA2, and LA3 may include a first light emitting area (or a first color light emitting area) LA1 from which a first color light exits, a second light emitting area (or a second color light emitting area) LA2 from which a second color light exits, and a third light emitting area (or a third color light emitting area) LA3 from which a third color light exits. In the present embodiments, the first color light may be a red light, the second color light may be a green light, and the third color light may be a blue light.

The first light emitting area LA1, the second light emitting area LA2, and the third light emitting area LA3 may have different sizes, however, they should not be limited thereto or thereby. The size of the first light emitting area LA1 may be the smallest, and the size of the third light emitting area LA3 may be the largest. Meanwhile, the size of the light emitting areas may be defined as a size in the plane defined by the first direction DR1 and the second direction DR2.

The first, second, and third light emitting areas LA1, LA2, and LA3 may have a variety of shapes when viewed in the plane (e.g., in a plan view). As an example, each of the first, second, and third light emitting areas LA1, LA2, and LA3 may have a polygonal shape, such as a quadrangular shape, an octagonal shape, etc., a circular shape, or an oval shape. As shown in FIGS. 6C and 6D, each of the first, second, and third light emitting areas LA1, LA2, and LA3 may have a rectangular shape, however, this is merely an example. According to some embodiments, each of the first, second, and third light emitting areas LA1, LA2, and LA3 may have a variety of shapes rather than the rectangular shape, and at least one of the first, second, or third light emitting areas LA1, LA2, or LA3 may have a shape different from those of the other light emitting areas of the first, second, and third light emitting areas LA1, LA2, and/or LA3. The shape of each of the first, second, and third light emitting areas LA1, LA2, and LA3 may correspond to the shape of the light emitting opening PX_OP (refer to FIG. 4) of the pixel definition layer PDL (refer to FIG. 4).

Referring to FIG. 6C, one first light emitting area LA1, two second light emitting areas LA2, and one third light emitting area LA3 may define one light emitting unit UA0. That is, one light emitting unit UA0 may include one first light emitting area LA1 and one third light emitting area LA3, which are arranged spaced apart from each other in the first direction DR1, and two second light emitting areas LA2 arranged spaced apart from each other in the second direction DR2. The light emitting unit UA0 refers to a unit of the light emitting areas that is repetitively arranged in the display area DP-DA (refer to FIG. 3). The light emitting unit UA0 may be provided in plural in the display device DD (refer to FIG. 2).

Four light emitting areas LA1, LA2, and LA3 may be arranged in a lozenge shape in one light emitting unit UA0. The light emitting units UA0 may be arranged in the second direction DR2 in pixel rows PXR. The light emitting units UA0 arranged in the pixel rows PXR adjacent to each other may be arranged staggered in the second direction DR2. The light emitting units UA0 arranged in pixel columns PXC adjacent to each other may be arranged staggered in the first direction DR1.

As shown in FIG. 6C, a first distance DT1-a between two second light emitting areas LA2 adjacent to each other in the first direction DR1 may be greater than a second distance DT2-a between the first light emitting area LA1 and the third light emitting area LA3 adjacent to the first light emitting area LA1 in the first direction DR1.

FIG. 6D is a plan view of the display area of the display device including the light emitting areas arranged different from that of FIG. 6C. Referring to FIG. 6D, the first light emitting area LA1 may overlap the second light emitting area LA2 in the first direction DR1 and may be spaced apart from the second light emitting area LA2 in the first direction DR1 in a first light emitting unit UA1 and a second light emitting unit UA2. In the first light emitting unit UA1 and the second light emitting unit UA2, the third light emitting area LA3 may be spaced apart from each of the first light emitting area LA1 and the second light emitting area LA2 in the second direction DR2.

A position of the third light emitting area LA3 in the first direction DR1 with respect to the first light emitting area LA1 and the second light emitting area LA2 in the first light emitting unit UA1 may be different from a position of the third light emitting area LA3 in the first direction DR1 with respect to the first light emitting area LA1 and the second light emitting area LA2 in the second light emitting unit UA2.

In the first light emitting unit UA1, the third light emitting area LA3 may be positioned relatively upward in the first direction DR1 with respect to the first light emitting area LA1 and the second light emitting area LA2. In the first light emitting unit UA1, the third light emitting area LA3 may be arranged to entirely overlap the first light emitting area LA1 in the second direction DR2 and may overlap a portion of the second light emitting area LA2 in the second direction DR2.

In the second light emitting unit UA2, the third light emitting area LA3 may be positioned relatively downward in the first direction DR1 with respect to the first light emitting area LA1 and the second light emitting area LA2. In the second light emitting unit UA2, the third light emitting area LA3 may be arranged to entirely overlap the second light emitting area LA2 in the second direction DR2 and may overlap a portion of the first light emitting area LA1 in the second direction DR2.

In the display device DD (refer to FIG. 2), the first light emitting unit UA1 and the second light emitting unit UA2 may be alternately arranged with each other in the first direction DR1 and the second direction DR2.

The first light emitting unit UA1 and the second light emitting unit UA2 may be alternately arranged with each other in the pixel column PXC along the first direction DR1. In addition, the first light emitting unit UA1 and the second light emitting unit UA2 may be alternately arranged with each other in the pixel row PXR along the second direction DR2. Due to the arrangement of the first light emitting unit UA1 and the second light emitting unit UA2, the third light emitting area LA3 of the first light emitting unit UA1 and the third light emitting area LA3 of the second light emitting unit UA2 may be arranged in a predetermined rule.

A distance between the third light emitting areas LA3 adjacent to each other may be changed depending on the arrangement of the first light emitting unit UA1 and the second light emitting unit UA2, which are adjacent to each other in the first direction DR1. As the first light emitting unit UA1 is alternately arranged with the second light emitting unit UA2 in the first direction DR1, a first portion PT1 in which the third light emitting area LA3 of the first light emitting unit UA1 is spaced apart from the third light emitting area LA3 of the second light emitting unit UA2 by a first distance DT1 may be alternately arranged with a second portion PT2 in which the third light emitting area LA3 of the first light emitting unit UA1 is spaced apart from the third light emitting area LA3 of the second light emitting unit UA2 by a third distance DT1-X smaller than the first distance DT1. The first portion PT1 may be alternately arranged with the second portion PT2 in each of the first direction DR1 and the second direction DR2.

In addition, due to the arrangement of the first light emitting unit UA1 and the second light emitting unit UA2 adjacent to the first light emitting unit UA1 in the first direction DR1, the second light emitting area LA2 of the first light emitting unit UA1 and the first light emitting area LA1 of the second light emitting unit UA2 may be arranged spaced apart from each other by a second distance DT2. The second distance DT2 may be smaller than the first distance DT1.

Meanwhile, according to some embodiments, the second distance DT2 may be substantially the same as the third distance DT1-X, however, the present disclosure should not be limited thereto or thereby.

Referring to FIGS. 6C and 6D, the display device may include the plural light emitting areas LA1, LA2, and LA3 defined in the display area DP-DA (refer to FIG. 3). The light emitting areas LA1, LA2, and LA3 may be arranged spaced apart from each other in the first direction DR1. In addition, some of the light emitting areas adjacent to each other in the first direction DR1 may be spaced apart from each other by the first distance DT1 or DT1-a, and the other of the light emitting areas adjacent to each other in the first direction DR1 may be spaced apart from each other by the second distance DT2 or DT2-a. The first distance DT1 or DT1-a may be greater than the second distance DT2 or DT2-a.

Meanwhile, the arrangements of the light emitting areas shown in FIGS. 6C and 6D are merely examples, and the arrangement of the light emitting areas, the shape of the light emitting units, and the type of the light emitting units should not be limited to those shown in FIGS. 6C and 6D. The arrangement of the light emitting areas that emit lights in different wavelength ranges may vary depending on the display quality required from the display device, the size of the display device, the purpose of use of the display device, etc.

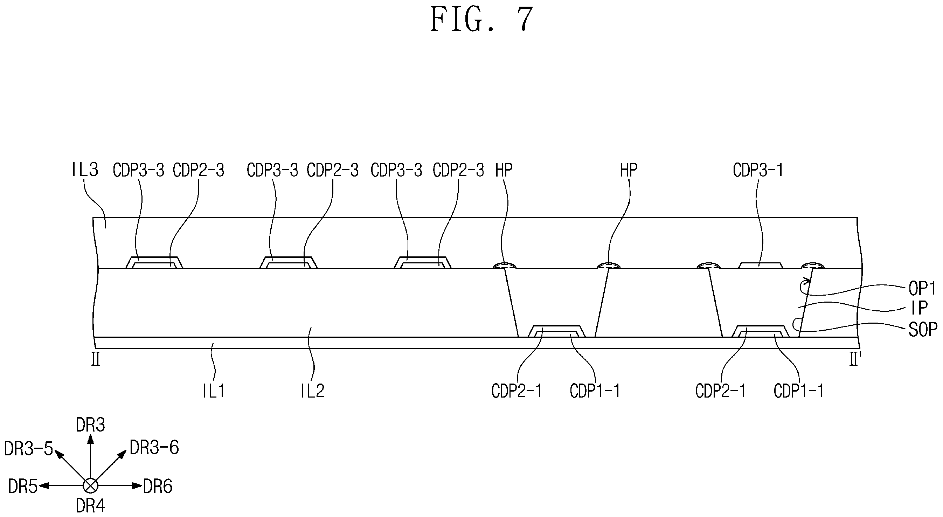

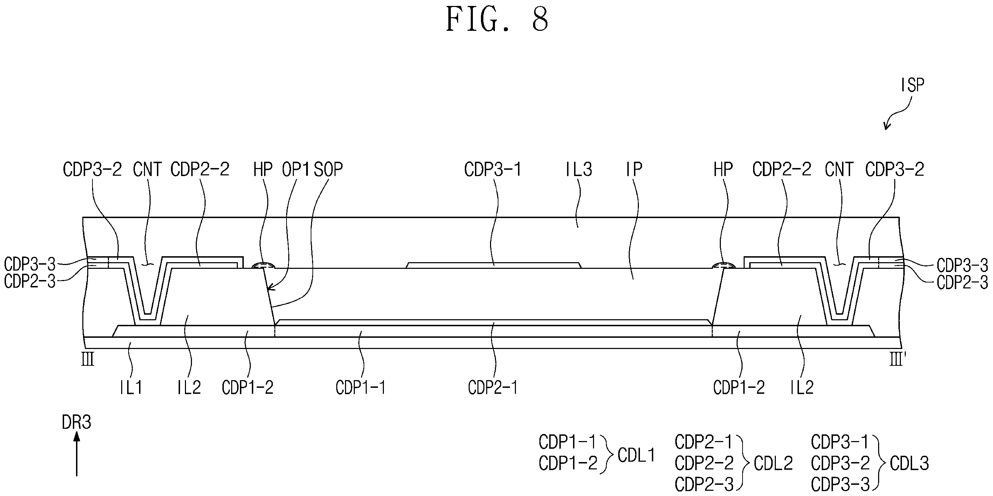

FIG. 7 is a cross-sectional view taken along a line II-II' of FIG. 6A. FIG. 8 is a cross-sectional view taken along a line III-III' of FIG. 6A. In FIGS. 7 and 8, the display panel DP (refer to FIG. 4) located on a lower surface of the first sensing insulating layer IL1 is omitted.

Referring to FIGS. 7 and 8, the input sensing panel ISP may include the first sensing insulating layer IL1, the second sensing insulating layer IL2, and the conductive patterns.

The first sensing insulating layer IL1 may be located on the display panel DP (refer to FIG. 4). The first sensing insulating layer IL1 may be located directly on the display panel DP (refer to FIG. 4). The first sensing insulating layer IL1 may be located directly on the thin film encapsulation layer TFE (refer to FIG. 4). The first sensing insulating layer IL1 may include an organic compound or an inorganic compound. The first sensing insulating layer IL1 may be an organic insulating layer including an organic compound. As an example, the first sensing insulating layer IL1 may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

The second sensing insulating layer IL2 may be located on the first sensing insulating layer IL1. The second sensing insulating layer IL2 may be located directly on the first sensing insulating layer IL1. The second sensing insulating layer IL2 may include an organic compound or an inorganic compound. The second sensing insulating layer IL2 may be an organic insulating layer including an organic compound. The second sensing insulating layer IL2 may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin. The second sensing insulating layer IL2 may be provided with a first opening OP1 and a contact hole CNT. The second sensing insulating layer IL2 may include an opening surface SOP that defines the first opening OP1. The opening surface SOP may be a surface surrounding the first opening OP1.

The first opening OP1 may overlap the first conductive layer CDL1 when viewed in the plane (e.g., in a plan view). A portion of the first conductive layer CDL1 may be exposed through the first opening OP1. The portion of the first conductive layer CDL1, which is exposed through the first opening OP1, may be a first-first conductive portion CDP1-1 described later.

The contact hole CNT may be spaced apart from the first opening OP1 when viewed in the plane (e.g., in a plan view). A portion of the first conductive layer CDL1 may be exposed through the contact hole CNT. The portion of the first conductive layer CDL1, which is exposed through the contact hole CNT, may be a first-second conductive portion CDP1-2 described later. A size of the contact hole CNT when viewed in the plane (e.g., in a plan view) may be smaller than a size of the first opening OP1 when viewed in the plane (e.g., in a plan view).

The conductive patterns may be the above-described mesh lines MSL1 and MSL2 (refer to FIG. 6A). The conductive patterns may include the first conductive layer CDL1 and the second conductive layer CDL2.

The first conductive layer CDL1 may include the first-first conductive portion CDP1-1 and the first-second conductive portion CDP1-2. The first conductive layer CDL1 may include a conductive material. The conductive material may include a metal or non-metal material. The conductive material may include at least one of Ti, Al, Mo, or Cu. As an example, the first conductive layer CDL1 may include Ti and Al. Different from the structure shown in FIGS. 7 and 8, the first conductive layer CDL1 may have a three-layer structure. As an example, the first conductive layer CDL1 may have a structure in which a first layer containing Ti, a second layer containing Al, and a third layer containing Ti are sequentially stacked.

Hereinafter, a sixth direction DR6 may be defined as a direction opposite to the fifth direction DR5 (refer to FIG. 6A), a third-fifth direction DR3-5 may be defined as a direction intersecting the third direction DR3 (refer to FIG. 6A) and the fifth direction DR5 (refer to FIG. 6A), and a third-sixth direction DR3-6 may be defined as a direction intersecting the third direction DR3 (refer to FIG. 6A) and the sixth direction DR6.

The first-first conductive portion CDP1-1 may be located in the first opening OP1. The first-first conductive portion CDP1-1 may overlap the first opening OP1 when viewed in the plane (e.g., in a plan view). At least a portion of the first-first conductive portion CDP1-1 may be exposed through the first opening OP1. The first-first conductive portion CDP1-1 may have a thickness equal to or greater than 2000 angstroms (or about 2000 angstroms) and equal to or smaller than 15000 angstroms (or about 15000 angstroms).

The first-second conductive portion CDP1-2 may be partially exposed through the contact hole CNT. The first-second conductive portion CDP1-2 may be electrically connected to the first-first conductive portion CDP1-1. The first-second conductive portion CDP1-2 may have substantially the same thickness as the thickness of the first-first conductive portion CDP1-1. The first-second conductive portion CDP1-2 may be provided integrally with the first-first conductive portion CDP1-1 to form the first conductive layer CDL1.

The second conductive layer CDL2 may include a second-first conductive portion CDP2-1, a second-second conductive portion CDP2-2, and a second-third conductive portion CDP2-3. The second conductive layer CDL2 may include a conductive material. The conductive material may include at least one of Ti, Al, Mo, or Cu. As an example, the second conductive layer CDL2 may include Ti and Al. Different from the structure shown in FIGS. 7 and 8, the second conductive layer CDL2 may have a three-layer structure. As an example, the second conductive layer CDL2 may have a structure in which a first layer containing Ti, a second layer containing Al, and a third layer containing Ti are sequentially stacked.

The second-first conductive portion CDP2-1 may be electrically connected to the first-first conductive portion CDP1-1. The second-first conductive portion CDP2-1 may be located directly on the first-first conductive portion CDP1-1. The second-first conductive portion CDP2-1 may be located directly on the first-first conductive portion CDP1-1 in the third direction DR3. The second-first conductive portion CDP2-1 may be located directly on the first-first conductive portion CDP1-1 in the third-fifth direction DR3-5. The second-first conductive portion CDP2-1 may be located directly on the first-first conductive portion CDP1-1 in the third-sixth direction DR3-6. The second-first conductive portion CDP2-1 may be directly in contact with the first-first conductive portion CDP1-1 in the third direction DR3, the third-fifth direction DR3-5, and the third-sixth direction DR3-6. A size of the first-first conductive portion CDP1-1 when viewed in the plane (e.g., in a plan view) may be smaller than a size of an area where the first-first conductive portion CDP1-1 is directly in contact with the second-first conductive portion CDP2-1. The thickness of the first-first conductive portion CDP1-1 may be greater than a thickness of the second-first conductive portion CDP2-1. A sum of the thickness of the first-first conductive portion CDP1-1 and the thickness of the second-first conductive portion CDP2-1 may be equal to or greater than 2000 angstroms (or about 2000 angstroms) and equal to or smaller than 37500 angstroms (or about 37500 angstroms). When the second-first conductive portion CDP2-1 is directly in contact with the first-first conductive portion CDP1-1 in the third direction DR3, the third-fifth direction DR3-5, and the third-sixth direction DR3-6, a resistance may decrease as a cross-sectional area through which electrons move increases.

An insulating pattern IP may be located on the second-first conductive portion CDP2-1 and may be located in the first opening OP1. The insulating pattern IP may include substantially the same material as the first sensing insulating layer IL1 or the second sensing insulating layer IL2. The insulating pattern IP may include an organic compound. The insulating pattern IP may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin. The insulating pattern IP may include a convex portion HP. The convex portion HP may overlap the opening surface SOP when viewed in the plane (e.g., in a plan view). A portion of the convex portion HP may be located on the second sensing insulating layer IL2.

The second-second conductive portion CDP2-2 may be electrically connected to the first-second conductive portion CDP1-2. The second-second conductive portion CDP2-2 may overlap the contact hole CNT when viewed in the plane (e.g., in a plan view). The second-second conductive portion CDP2-2 may be located directly on the portion of the first-second conductive portion CDP1-2, which is exposed through the contact hole CNT.

The second-third conductive portion CDP2-3 may be spaced apart from the first conductive layer CDL1 when viewed in the plane (e.g., in a plan view). The second-third conductive portion CDP2-3 may be located on the second sensing insulating layer IL2. The second-third conductive portion CDP2-3 may be electrically connected to the second-second conductive portion CDP2-2. The second-second conductive portion CDP2-2 may be formed by extending the second-third conductive portion CDP2-3. The second-third conductive portion CDP2-3 may have a thickness equal to or greater than 2000 angstroms (or about 2000 angstroms) and equal to or smaller than 15000 angstroms (or about 15000 angstroms).

The input sensing panel ISP may further include a third conductive layer CDL3. The third conductive layer CDL3 may include a third-first conductive portion CDP3-1, a third-second conductive portion CDP3-2, and a third-third conductive portion CDP3-3. The third conductive layer CDL3 may include a conductive material. The conductive material may include at least one of Ti, Al, Mo, or Cu. As an example, the third conductive layer CDL3 may include Ti and Al. Different from those shown in FIGS. 7 and 8, the third conductive layer CDL3 may have a three-layer structure. As an example, the third conductive layer CDL3 may have a structure in which a first layer containing Ti, a second layer containing Al, and a third layer containing Ti are sequentially stacked.

The third-first conductive portion CDP3-1 may be located on the insulating pattern IP. The third-first conductive portion CDP3-1 may overlap the first opening OP1 when viewed in the plane (e.g., in a plan view). The third-first conductive portion CDP3-1 may overlap the first-first conductive portion CDP1-1 and the second-first conductive portion CDP2-1 when viewed in the plane (e.g., in a plan view).

The third-second conductive portion CDP3-2 may be located directly on the second-second conductive portion CDP2-2. When the third-second conductive portion CDP3-2 is located directly on the second-second conductive portion CDP2-2, a resistance may decrease as a cross-sectional area through which electrons move increases. A size of the third-second conductive portion CDP3-2 when viewed in the plane (e.g., in a plan view) may be equal to or greater than a size of the second-second conductive portion CDP2-2 when viewed in the plane (e.g., in a plan view).

The third-third conductive portion CDP3-3 may be located directly on the second-third conductive portion CDP2-3. When the third-third conductive portion CDP3-3 is located directly on the second-third conductive portion CDP2-3, a resistance may decrease as a cross-sectional area through which electrons move increases. The third-third conductive portion CDP3-3 may be electrically connected to the third-second conductive portion CDP3-2. The third-second conductive portion CDP3-2 may be formed by extending the third-third conductive portion CDP3-3. A size of the third-third conductive portion CDP3-3 may be equal to or greater than a size of the second-third conductive portion CDP2-3 when viewed in the plane (e.g., in a plan view). When the size of the third-third conductive portion CDP3-3 when viewed in the plane (e.g., in a plan view) is greater than the size of the second-third conductive portion CDP2-3 when viewed in the plane (e.g., in a plan view) and the third-third conductive portion CDP3-3 is located directly on the second-third conductive portion CDP2-3, a contact area between the third-third conductive portion CDP3-3 and the second-third conductive portion CDP2-3 may increase, and thus, the resistance may decrease. A sum of the thickness of the second-third conductive portion CDP2-3 and a thickness of the third-third conductive portion CDP3-3 may be equal to or greater than 2000 angstroms (or about 2000 angstroms) and equal to or smaller than 37500 angstroms (or about 37500 angstroms).

The input sensing panel ISP may further include the third sensing insulating layer IL3 located on the third conductive layer CDL3. The third sensing insulating layer IL3 may planarize the input sensing panel ISP. Different from the structures shown in FIGS. 7 and 8, the third sensing insulating layer IL3 may have a curved shape without being completely planarized due to a difference in height between the third-first conductive portion CDP3-1 and the third-second conductive portion CDP3-2. The third sensing insulating layer IL3 may include an organic compound or an inorganic compound. The third sensing insulating layer IL3 may be an organic insulating layer including an organic compound. The third sensing insulating layer IL3 may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

Hereinafter, a method of manufacturing the display device will be described. Detailed descriptions of the components described above will be omitted.

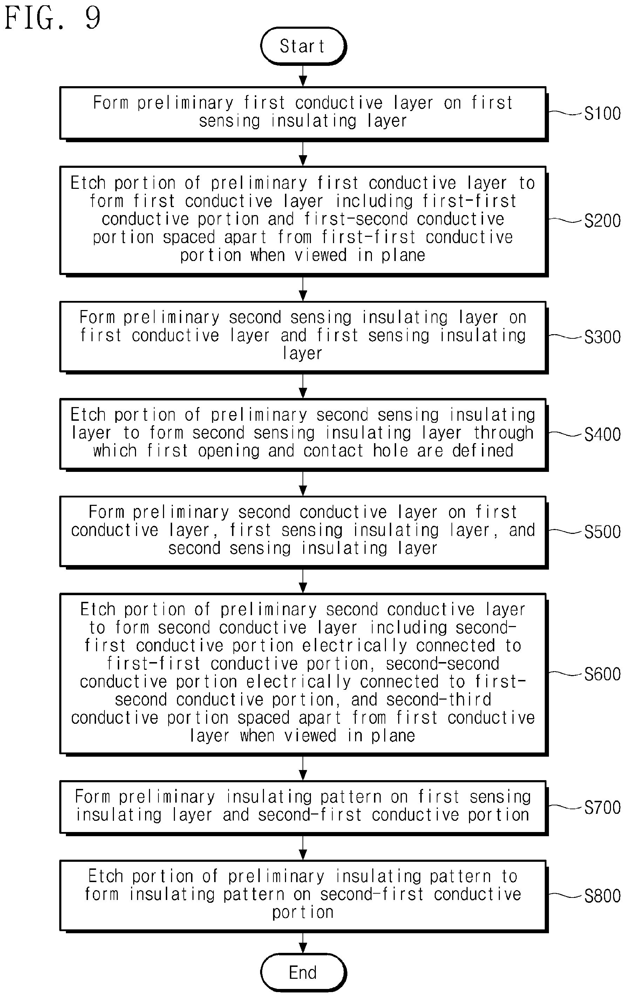

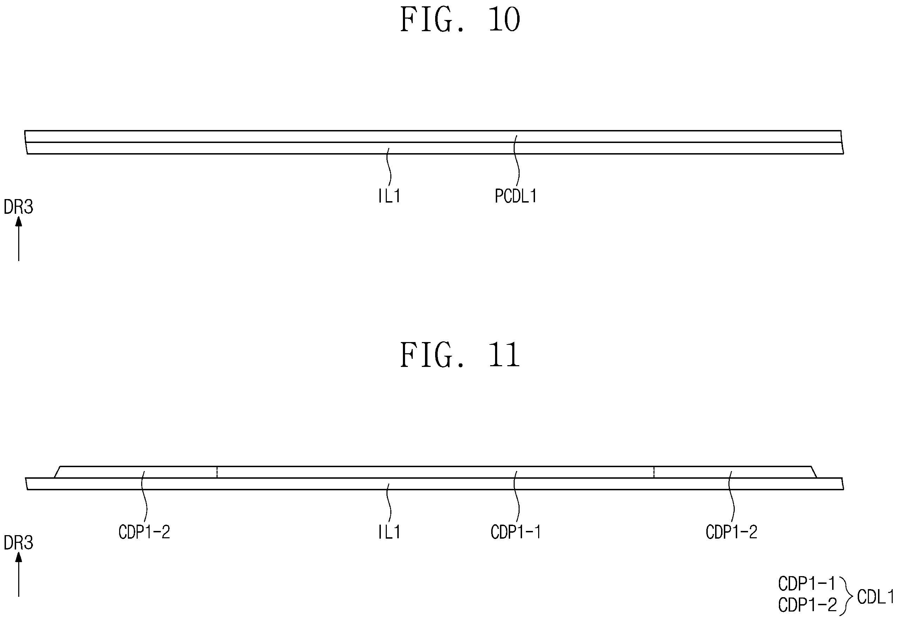

FIG. 9 is a flowchart illustrating aspects of a manufacturing method of the display device according to some embodiments of the present disclosure. Although FIG. 9 illustrates various operations in a manufacturing method of a display device, embodiments according to the present disclosure are not limited thereto. According to some embodiments, the manufacturing method of a display device may include additional operations or fewer operations, or the order of operations may vary unless otherwise stated or implied, without departing from the scope of embodiments according to the present disclosure. FIGS. 10 to 19 are cross-sectional views illustrating processes of the manufacturing method of the display device according to some embodiments of the present disclosure.

Referring to FIG. 9, the manufacturing method of the display device includes forming a preliminary first conductive layer on the first sensing insulating layer (S100), etching a portion of the preliminary first conductive layer to form the first conductive layer including the first-first conductive portion and the first-second conductive portion that does not overlap the first-first conductive portion (S200), forming a preliminary second sensing insulating layer on the first conductive layer and the first sensing insulating layer (S300), etching a portion of the preliminary second sensing insulating layer to form the second sensing insulating layer through which the first opening and the contact hole are defined (S400), forming a preliminary second conductive layer on the first conductive layer, the first sensing insulating layer, and the second sensing insulating layer (S500), etching a portion of the preliminary second conductive layer to form the second conductive layer including the second-first conductive portion electrically connected to the first-first conductive portion, the second-second conductive portion electrically connected to the first-second conductive portion, and the second-third conductive portion spaced apart from the first conductive layer when viewed in the plane (e.g., in a plan view) (S600), forming a preliminary insulating pattern on the first sensing insulating layer and the second-first conductive portion (S700), and etching a portion of the preliminary insulating pattern to form the insulating pattern on the second-first conductive portion (S800).

Referring to FIG. 10, according to the manufacturing method of the display device, the preliminary first conductive layer PCDL1 may be formed on the first sensing insulating layer IL1. The preliminary first conductive layer PCDL1 may be formed by a physical vapor deposition (PVD) method, a chemical vapor deposition (CVD) method, or an atomic layer deposition (ALD) method. As an example, the preliminary first conductive layer PCDL1 may be formed by the physical vapor deposition (PVD) method. In the forming of the preliminary first conductive layer PCDL1, the preliminary first conductive layer PCDL1 may be directly formed on the first sensing insulating layer IL1. The preliminary first conductive layer PCDL1 may include the conductive material. The conductive material may include at least one of Ti, Al, Mo, or Cu. As an example, the preliminary first conductive layer PCDL1 may include Ti and Al. Different from the structure shown in FIG. 10, the preliminary first conductive layer PCDL1 may have the three-layer structure. As an example, the forming of the preliminary first conductive layer PCDL1 on the first sensing insulating layer IL1 may include forming the first layer containing Ti on the first sensing insulating layer IL1, forming the second layer containing Al on the first layer containing Ti, and forming the third layer containing Ti on the second layer containing Al. Since the third layer containing Ti has a reflectance lower than the second layer containing Al, a visibility of the display device may be improved.

Referring to FIG. 11, according to the manufacturing method of the display device, the portion of the preliminary first conductive layer PCDL1 (refer to FIG. 10) may be etched, and the first conductive layer CDL1 including the first-first conductive portion CDP1-1 and the first-second conductive portion CDP1-2 may be formed. The first conductive layer CDL1 may be formed through a dry etching process or a wet etching process.

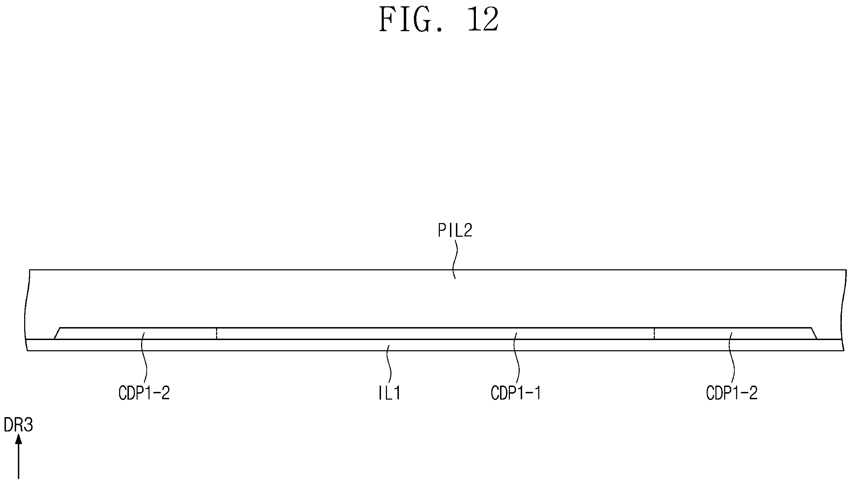

Referring to FIG. 12, according to the manufacturing method of the display device, the preliminary second sensing insulating layer PIL2 may be formed on the first conductive layer CDL1 and the first sensing insulating layer IL1. The preliminary second sensing insulating layer PIL2 may be formed by various methods, such as a vacuum deposition method, a spin coating method, a cast method, an LB (Langmuir-Blodgett) method, an inkjet printing method, a laser printing method, an LITI (Laser Induced Thermal Imaging) method, etc. As an example, the preliminary second sensing insulating layer PIL2 may be formed by the inkjet printing method. In the forming of the preliminary second sensing insulating layer PIL2, the preliminary second sensing insulating layer PIL2 may include the organic compound or the inorganic compound. The preliminary second sensing insulating layer PIL2 may include the organic compound. The preliminary second sensing insulating layer PIL2 may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin. The preliminary second sensing insulating layer PIL2 may be formed by a coating or deposition method. The preliminary second sensing insulating layer PIL2 may be formed by a photo etching process.

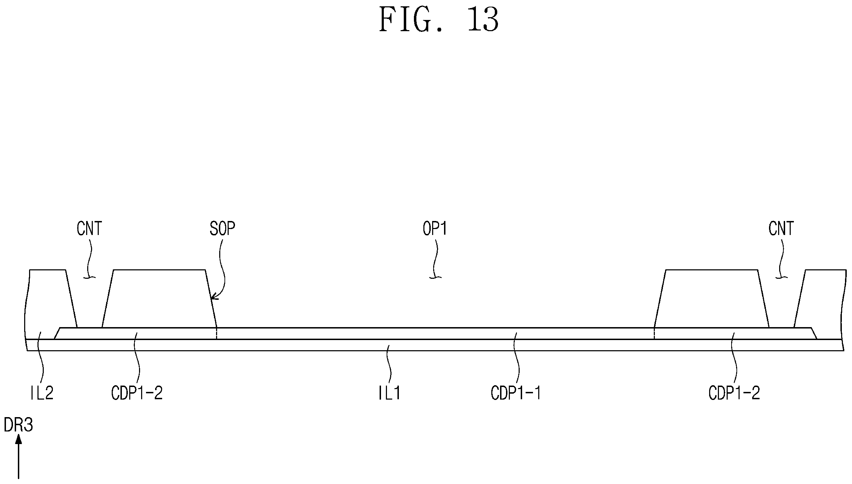

Referring to FIGS. 7 and 13, according to the manufacturing method of the display device, the second sensing insulating layer IL2 through which the first opening OP1 and the contact hole CNT are defined may be formed. In the forming of the second sensing insulating layer IL2, the size in the plane of the contact hole CNT may be smaller than the size in the plane of the first opening OP1. Each of the contact hole CNT and the first opening OP1 may be formed to completely penetrate the preliminary second sensing insulating layer PIL2 (refer to FIG. 12). Each of the first opening OP1 and the contact hole CNT may overlap the first-first conductive portion CDP1-1 and the first-second conductive portion CDP1-2 when viewed in the plane (e.g., in a plan view). At least the portion of the first-first conductive portion CDP1-1 may be exposed through the first opening OP1. The portion of the first-second conductive portion CDP1-2 may be exposed through the contact hole CNT. Due to the contact hole CNT, a space in which the portion of the second-second conductive portion CDP2-2 is located may be provided on the first-second conductive portion CDP1-2.

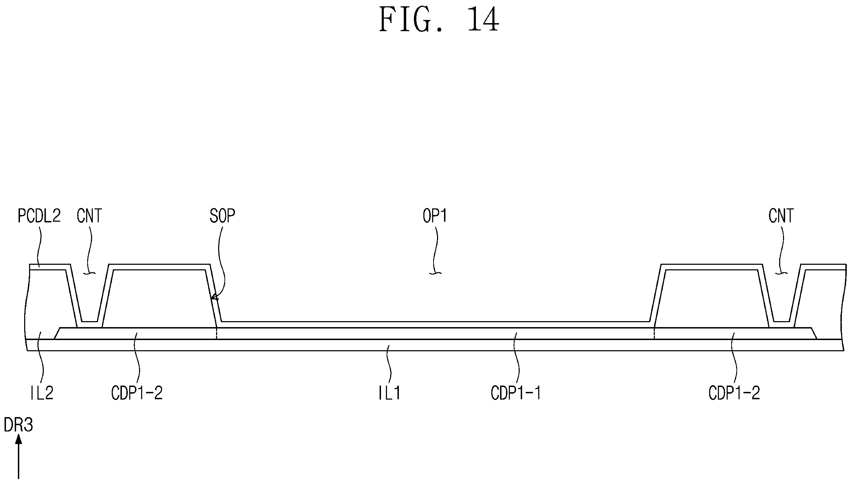

Referring to FIG. 14, according to the manufacturing method of the display device, the preliminary second conductive layer PCDL2 may be formed on the first sensing insulating layer IL1 and the second sensing insulating layer IL2. The preliminary second conductive layer PCDL2 may be formed by a physical vapor deposition (PVD) method, a chemical vapor deposition (CVD) method, or an atomic layer deposition (ALD) method. As an example, the preliminary second conductive layer PCDL2 may be formed by the physical vapor deposition (PVD) method. In the forming of the preliminary second conductive layer PCDL2, the preliminary second conductive layer PCDL2 may be located directly on the first conductive layer CDL1, the first sensing insulating layer IL1, and the second sensing insulating layer IL2. The preliminary second conductive layer PCDL2 may include the conductive material. The conductive material may include at least one of Ti, Al, Mo, or Cu.

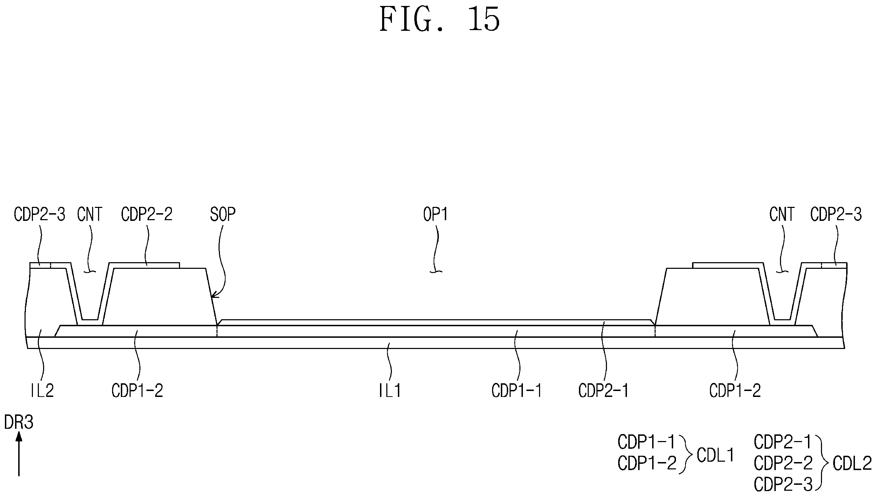

Referring to FIGS. 7 and 15, according to the manufacturing method of the display device, the second conductive layer CDL2 including the second-first conductive portion CDP2-1 electrically connected to the first-first conductive portion CDP1-1, the second-second conductive portion CDP2-2 electrically connected to the first-second conductive portion CDP1-2, and the second-third conductive portion CDP2-3 spaced apart from the first conductive layer CDL1 may be formed. The etching process of the second conductive layer CDL2 may be a dry etching process or a wet etching process. The second-first conductive portion CDP2-1 may overlap the first-first conductive portion CDP1-1 when viewed in the plane (e.g., in a plan view). The size in the plane of the second-first conductive portion CDP2-1 may be greater than the size in the plane of the first-first conductive portion CDP1-1.

Referring to FIGS. 7 and 15, the second-first conductive portion CDP2-1 may be located directly on the first-first conductive portion CDP1-1. As the contact area in which the second-first conductive portion CDP2-1 is directly in contact with the first-first conductive portion CDP1-1 increases, the resistance may be reduced. The cross-sectional area through which the electrons move may increase more when the second-first conductive portion CDP2-1 is located on the first-first conductive portion CDP1-1 than when the second-first conductive portion CDP2-1 is not located on the first-first conductive portion CDP1-1, and thus, the resistance may be reduced. When the second-first conductive portion CDP2-1 is not located on the first-first conductive portion CDP1-1 and the first-first conductive portion CDP1-1 is formed to have a thickness equal to or greater than 6000 angstroms (or about 6000 angstroms) to reduce an electrical resistance, a yield may be lowered because the etching process is not performed properly in the process of forming the first-first conductive portion CDP1-1. As a result, defects such as cracks may occur, and a durability of the display device may be reduced.

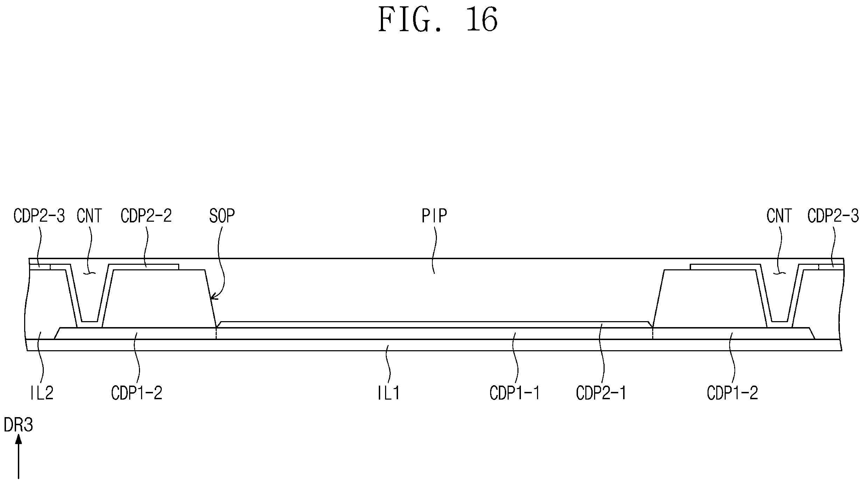

Referring to FIG. 16, according to the manufacturing method of the display device, the preliminary insulating pattern PIP may be formed on the first sensing insulating layer IL1 and the second-first conductive portion CDP2-1. The preliminary insulating pattern PIP may include a photoresist. The manufacturing method of the display device may further include irradiating a light onto a portion of the preliminary insulating pattern PIP to form the insulating pattern IP. In the forming of the preliminary insulating pattern PIP, the preliminary insulating pattern PIP may be located directly on the first sensing insulating layer IL1 and the second-first conductive portion CDP2-1. The preliminary insulating pattern PIP may be located directly on the opening surface SOP. In the depositing of the preliminary insulating pattern PIP, a portion of the preliminary insulating pattern PIP may be located on the second sensing insulating layer IL2.

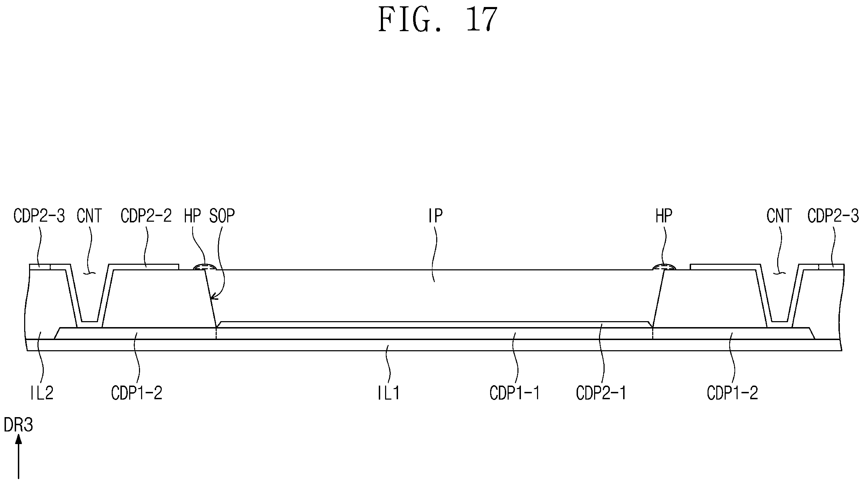

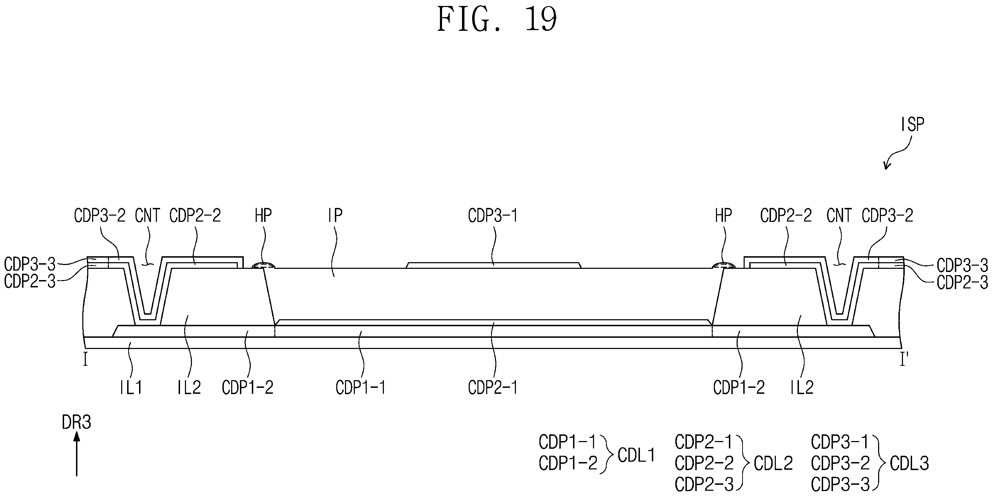

Referring to FIG. 17, according to the manufacturing method of the display device, the insulating pattern IP may be formed on the second-first conductive portion CDP2-1. The etching of the portion of the preliminary insulating pattern PIP (refer to FIG. 16) to form the insulating pattern IP may include exposing the preliminary insulating pattern PIP (refer to FIG. 16) to the light and developing the exposed preliminary insulating pattern PIP (refer to FIG. 16) to form the insulating pattern IP. The insulating pattern IP may be located directly on the second-first conductive portion CDP2-1. As shown in FIG. 7, the insulating pattern IP may be located directly on the first sensing insulating layer IL1. The insulating pattern IP may be located in the first opening OP1. The insulating pattern IP may overlap the first opening OP1 when viewed in the plane (e.g., in a plan view). The insulating pattern IP may be located on the first-first conductive portion CDP1-1 and the second-first conductive portion CDP2-1 exposed through the first opening OP1 to electrically separate the third-first conductive portion CDP3-1 (refer to FIG. 19) from each of the first-first conductive portion CDP1-1 and the second-first conductive portion CDP2-1. The insulating pattern IP may include the convex portion HP that overlaps the opening surface SOP and protrudes above the second sensing insulation layer IL2. A portion where the insulating pattern IP is located on the second sensing insulating layer IL2 may be defined as the convex portion HP. Convex portion HP may be formed on the opening surface SOP as a result of the photolithography process.

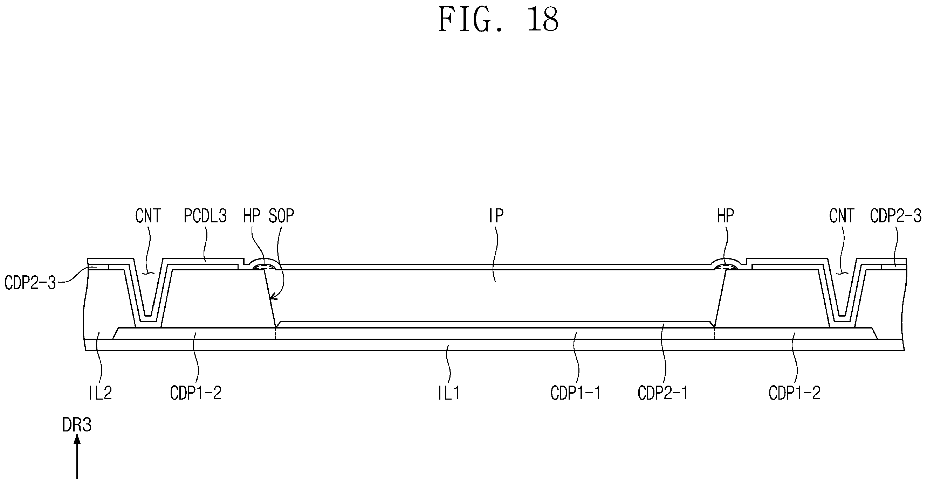

Referring to FIG. 18, the manufacturing method of the display device may further include forming a preliminary third conductive layer PCDL3. The preliminary third conductive layer PCDL3 may be directly formed on the second-third conductive portion CDP2-3, the second-second conductive portion CDP2-2, the second sensing insulating layer IL2, and the insulating pattern IP. The preliminary third conductive layer PCDL3 may be formed by a physical vapor deposition (PVD) method, a chemical vapor deposition (CVD) method, or an atomic layer deposition (ALD) method. As an example, the preliminary third conductive layer PCDL3 may be formed by the physical vapor deposition (PVD) method. The preliminary third conductive layer PCDL3 may include a conductive material. The conductive material may include at least one of Ti, Al, Mo, or Cu. As an example, the preliminary third conductive layer PCDL3 may include Ti and Al. Different from the structure of FIG. 18, the preliminary third conductive layer PCDL3 may have a three-layer structure. As an example, the forming of the preliminary third conductive layer PCDL3 on the second-third conductive portion CDP2-3, the second-second conductive portion CDP2-2, the second sensing insulating layer IL2, and the insulating pattern IP may include forming a first layer containing Ti on the second-third conductive portion CDP2-3, the second-second conductive portion CDP2-2, the second sensing insulating layer IL2, and the insulating pattern IP, forming a second layer containing Al on the first layer containing Ti, and forming a third layer containing Ti on the second layer containing Al. Since the third layer containing Ti has a reflectance lower than the second layer containing Al, the visibility may be improved.

Referring to FIG. 19, the manufacturing method of the display device may further include forming the third conductive layer CDL3. The etching process of the third conductive layer CDL3 may be a photo-etching process. The size in the plane of the third-third conductive portion CDP3-3 may be equal to or greater than the size in the plane of the second-third conductive portion CDP2-3. The cross-sectional area through which the electrons move may increase more when the third-third conductive portion CDP3-3 is located on the second-third conductive portion CDP2-3 than when the third-third conductive portion CDP3-3 is not located on the second-third conductive portion CDP2-3, and thus, the resistance may be reduced. When the third-third conductive portion CDP3-3 is not located on the second-third conductive portion CDP2-3 and the second-third conductive portion CDP2-3 is formed to have a thickness equal to or greater than 6000 angstroms (or about 6000 angstroms) to reduce an electrical resistance, a yield may be lowered because the etching process is not performed properly in the process of forming the second-third conductive portion CDP2-3. As a result, defects such as cracks may occur, and a durability of the display device may be reduced.

The manufacturing method of the display device may further include forming the third sensing insulating layer IL3 (refer to FIG. 7) on the third conductive layer CDL3. The third sensing insulating layer IL3 (refer to FIG. 7) may be located directly on the third conductive layer CDL3. The third sensing insulating layer IL3 (refer to FIG. 7) may include the organic compound or the inorganic compound. The third sensing insulating layer IL3 (refer to FIG. 7) may include the organic compound. The third sensing insulating layer IL3 (refer to FIG. 7) may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

Although aspects of some embodiments of the present disclosure have been described, it is understood that embodiments according to the present disclosure should not be limited to these embodiments but various changes and modifications can be made by one ordinary skilled in the art within the scope of the present disclosure as defined by the appended claims, and their equivalents. Therefore, the disclosed subject matter should not be limited to any single embodiment described herein, and the scope of the present inventive concept shall be determined according to the appended claims, and their equivalents.

## Claims

1. A display device comprising:
a display panel (DP) comprising a plurality of light emitting areas; and
an input sensing panel (ISP) comprising:
a first sensing insulating layer (IL1) on the display panel;
a second sensing insulating layer (IL2) on the first sensing insulating layer and having a first opening and a contact hole, which are defined therethrough;
an insulating pattern (IP); and
a plurality of conductive patterns,
wherein the plurality of conductive patterns comprise a first conductive layer (CDL1) and a second conductive layer (CDL2),
the first conductive layer (CDL1) comprises:
a first-first conductive portion (CDP1-1) in the first opening (OP1); and
a first-second conductive portion (CDP1-2) partially exposed through the contact hole (CNT),
the second conductive layer (CDL2) comprises:
a second-first conductive portion (CDP2-1) electrically connected to the first-first conductive portion;
a second-second conductive portion (CDP2-2) electrically connected to the first-second conductive portion; and
a second-third conductive portion (CDP2-3) spaced apart from the first conductive layer in a plan view, and the insulating pattern is on the second-first conductive portion and in the first opening (OP1).

2. The display device of claim 1, wherein the first-first conductive portion (CDP1-1) has a thickness greater than a thickness of the second-first conductive portion (CDP2-1).

3. The display device of claim 1 or 2, wherein a sum of a thickness of the first-first conductive portion (CDP1-1) and a thickness of the second-first conductive portion (CDP2-1) is equal to or greater than 2000 angstroms and equal to or smaller than 37500 angstroms.

4. The display device of any of the preceding claims, wherein the insulating pattern (IP) comprises at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin.

5. The display device of any of the preceding claims, further comprising a third conductive layer (CDL3) comprising a third-first conductive portion (CDP3-1) on the insulating pattern (IP), a third-second conductive portion (CDP3-2) directly on the second-second conductive portion (CDP2-2), and a third-third conductive portion directly on the second-third conductive portion.

6. The display device of any of the preceding claims, wherein the second sensing insulating layer (IL2) further comprises an opening surface that defines the first opening, and the insulating pattern comprises a convex portion that overlaps the opening surface in the plan view.

7. The display device of claim 5 or 6, wherein the third-second conductive portion (CDP3-2) has a size equal to or greater than a size of the second-second conductive portion (CDP2-2) in the plan view.

8. The display device of any of claims 5 to 7, wherein the third-third conductive portion (CDP3-3) has a size equal to or greater than a size of the second-third conductive portion (CDP2-3) in the plan view.

9. The display device of any of claims 5 to 8, wherein a sum of a thickness of the second-third conductive portion (CDP2-3) and a thickness of the third-third conductive portion (CDP3-3) is equal to or greater than 2000 angstroms and equal to or smaller than 37500 angstroms.

10. The display device of any of claims 5 to 9, further comprising a third sensing insulating layer (IP3) on the third conductive layer (CDL3).

11. The display device of any of the preceding claims, wherein each of the first conductive layer (CDL1) and the second conductive layer (CDL2) comprises a conductive material, and the conductive material comprises at least one of Ti, Al, Mo, or Cu.

12. The display device of any of the preceding claims, wherein the light emitting areas do not overlap the conductive patterns in the plan view.

13. The display device of any of the preceding claims, wherein the display panel further comprises:
a light emitting element comprising a first electrode, a light emitting layer on the first electrode, and a second electrode on the light emitting layer; and
an encapsulation layer (TFE) on the light emitting element.

14. The display device of claim 13, wherein the first sensing insulating layer (IL1) is directly on the encapsulation layer (TFE).

15. A method of manufacturing a display device of any of the preceding claims, comprising:
forming a preliminary first conductive layer (PCDL1) on a first sensing insulating layer (IL1);
etching a portion of the preliminary first conductive layer (PCDL1) to form a first conductive layer (CDL1) comprising a first-first conductive portion and a first-second conductive portion;
forming a preliminary second sensing insulating layer on the first conductive layer (CDL1) and the first sensing insulating layer;
etching a portion of the preliminary second sensing insulating layer to form a second sensing insulating layer (IL2) through which a first opening exposing at least a portion of the first-first conductive portion and a contact hole exposing a portion of the first-second conductive portion are defined;
forming a preliminary second conductive layer (PCDL2) on the first conductive layer (CDL1), the first sensing insulating layer, and the second sensing insulating layer;
etching a portion of the preliminary second conductive layer (PCDL2) to form a second conductive layer (CDL2) comprising a second-first conductive portion electrically connected to the first-first conductive portion, a second-second conductive portion electrically connected to the first-second conductive portion, and a second-third conductive portion spaced apart from the first conductive layer (CDL1) in a plan view;
forming a preliminary insulating pattern on the first sensing insulating layer and the second-first conductive portion; and
etching a portion of the preliminary insulating pattern to form an insulating pattern on the second-first conductive portion, wherein the insulating pattern is on the second-first conductive portion and in the first opening.
